# EUROPEAN PATENT APPLICATION

(11) **EP 4 318 848 A1**
(43) Date of publication of application: **07.02.2024**
(21) Application number: 22787560.6
(22) Date of filing: 13.04.2022
(51) Int. Cl.: H02J 3/38, H02H 11/00

(54) **PHOTOVOLTAIC SYSTEM, DIRECT-CURRENT COMBINER BOX AND WIRING ERROR DETECTION METHOD**

(30) Priority: 16.04.2021 CN 202110412834
(71) Applicant: Huawei Digital Power Technologies Co., Ltd., Shenzhen, Guangdong 518043 (CN)
(72) Inventor: GAO, Yongbing, Shenzhen, Guangdong 518043 (CN); LIN, Tiansan, Shenzhen, Guangdong 518043 (CN); ZHANG, Fangpo, Shenzhen, Guangdong 518043 (CN); LIN, Jianfei, Shenzhen, Guangdong 518043 (CN)
(74) Representative: Huawei European IPR
(86) International application number: PCT/CN2022/086593
(87) International publication number: WO 2022/218338

(57) **Abstract**

This application discloses a photovoltaic system, a direct current combiner box, and a method for detecting a wiring error. The photovoltaic system includes M direct current combiner boxes and N inverters. Positive output ends and negative output ends of the M direct current combiner boxes are connected to a direct current bus. An input end of each direct current combiner box is connected to a corresponding photovoltaic string. Input ends of the N inverters are connected to the direct current bus. Each of the M direct current combiner boxes includes a soft-start circuit. The soft-start circuit includes at least a switch device and an output capacitor that are connected in series. The output capacitor is connected in parallel to the positive output end and the negative output end of the direct current combiner box. A switch device in at least one of the M direct current combiner boxes is turned on, an output capacitor connected in series to the turned-on switch device is charged, and a remaining switch device is turned off. Whether a wiring error occurs in the M direct current combiner boxes is determined based on voltages of output capacitors in at least some of the soft-start circuits. In this solution, whether a wiring error occurs in the direct current combiner box is determined by measuring the voltage of the output capacitor.

## Description

This application claims priority to Chinese Patent Application No. 202110412834.3, filed with the China National Intellectual Property Administration on April 16, 2021 and entitled "PHOTOVOLTAIC SYSTEM, DIRECT CURRENT COMBINER BOX, AND METHOD FOR DETECTING WIRING ERROR", which is incorporated herein by reference in its entirety.

### TECHNICAL FIELD

This application relates to the field of photovoltaic power generation technologies, and in particular, to a photovoltaic system, a direct current combiner box, and a method for detecting a wiring error.

### BACKGROUND

As the global environment is increasingly polluted and energy is depleted, photovoltaic power generation is gaining popularity as green energy. To facilitate control with increased power of a photovoltaic system, each of output ends of a plurality of direct current combiner boxes is generally connected to a direct current bus, that is, output ends of the plurality of direct current combiner boxes are connected in parallel, and each direct current combiner box is connected to a corresponding photovoltaic string. A plurality of inverters may be connected to the direct current bus. For example, each of input ends of the plurality of inverters is connected to the direct current bus. The inverter is configured to convert a direct current into an alternating current and provide the alternating current to an alternating current power grid or an electrical device.

Because an output end of each direct current combiner box includes a positive output end and a negative output end, in a normal case, the positive output end of each direct current combiner box is supposed to connect to a direct current positive bus, and the negative output end of each direct current combiner box is supposed to connect to a direct current negative bus. However, when wrong connections occur, the positive output end of the direct current combiner box may be connected to the direct current negative bus, and the negative output end of the direct current combiner box may be connected to the direct current positive bus. In other words, contrary connections occur. In addition, the positive output end and the negative output end of the direct current combiner box may be short-circuited together.

Because the output ends of the plurality of direct current combiner boxes are all connected in parallel to the direct current bus, when one output is incorrectly connected, connections between other direct current combiner boxes and the direct current bus are affected. Therefore, it is necessary to determine, in a timely manner, whether a wiring error occurs at the output end of the direct current combiner box, that is, the direct current bus side.

### SUMMARY

To resolve the foregoing technical problem, this application provides a photovoltaic system, a direct current combiner box, and a method for detecting a wiring error, to detect, in a timely manner, whether a wiring error occurs at an output end of the direct current combiner box.

The photovoltaic system provided in this embodiment of this application includes at least two direct current combiner boxes and at least two inverters, for example, M direct current combiner boxes and N inverters. Both M and N are integers greater than or equal to 2. Positive output ends and negative output ends of the M direct current combiner boxes are respectively configured to connect to a direct current positive bus and a direct current negative bus. An input end of each of the M direct current combiner boxes is configured to connect to a corresponding photovoltaic string. Positive input ends and negative input ends of the N inverters are respectively configured to connect the direct current positive bus and the direct current negative bus. Each of the M direct current combiner boxes includes a soft-start circuit. The soft-start circuit includes at least a switch device and an output capacitor that are connected in series. The output capacitor is connected in parallel to the positive output end and the negative output end of the direct current combiner box. A switch device in at least one of the M direct current combiner boxes is turned on, an output capacitor connected in series to the turned-on switch device is charged, and a remaining switch device is turned off. Whether a wiring error occurs in the M direct current combiner boxes is determined based on voltages of output capacitors in at least some of the soft-start circuits.

According to the photovoltaic system provided in this embodiment of this application, a soft-start circuit is specifically added to the direct current combiner box. The soft-start circuit includes an output capacitor and a switch device that are connected in series. The output capacitor is connected in parallel to the positive output end and the negative output end of the direct current combiner box. Before the direct current combiner box is connected to the direct current bus, the switch device is turned on to charge the output capacitor. Then, a voltage on the output capacitor is measured to determine whether a wiring error occurs in one or more direct current combiner boxes. The photovoltaic system can quickly identify whether a wiring error occurs at the positive output end and the negative output end of the direct current combiner box. Because the output capacitor is connected in parallel to the output end of the direct current combiner box, when connections to the positive output end and the negative output end of the direct current combiner box are reversed, or a short circuit occurs between the positive output end or the negative output end of the direct current combiner box, a voltage on the output capacitor is caused to change. For example, when connections to the positive output end and the negative output end of the direct current combiner box are reversed, a voltage on the output capacitor is a negative voltage. When a short circuit occurs between the positive output end and the negative output end of the direct current combiner box, the output capacitor is short-circuited, and the voltage on the output voltage is almost 0. Therefore, in this embodiment of this application, whether a wiring error occurs in the direct current combiner box is determined by detecting the voltage on the output capacitor.

It should be understood that, because output ends of all direct current combiner boxes are connected to the direct current bus, and output capacitors in the direct current combiner boxes each are connected in parallel to the output end, when a wiring error occurs in one direct current combiner box, a voltage on an output voltage of another combiner box is affected. A specific quantity of output capacitors to be detected is not limited in this embodiment of this application. Voltages on some output capacitors may be detected, or voltages on some output capacitors may be detected.

According to the photovoltaic system provided in this embodiment of this application, a switch device in one of the direct current combiner boxes may be controlled to be turned on to charge a corresponding output capacitor, and a voltage on another output capacitor is detected to determine whether a wiring error occurs. In addition, switch devices in at least two of the direct current combiner boxes may alternatively be controlled to be turned on to charge corresponding output capacitors, and a voltage on a remaining output capacitor is detected to determine whether a wiring error occurs. The following separately describes the foregoing two specific implementations.

In a first implementation, the controller controls a switch device in one direct current combiner box to be turned on, and all remaining switch devices to be turned off; and when a voltage of at least one output capacitor in a remaining direct current combiner box is a negative voltage, determines that a wiring error occurs in the M direct current combiner boxes.

In a second implementation, the controller controls switch devices in at least two of the M direct current combiner boxes to be turned on, and all remaining switch devices to be turned off; and when a voltage of an output capacitor in a remaining direct current combiner box is less than a preset voltage value, determines that a wiring error occurs in the M direct current combiner boxes.

In the first implementation in the foregoing two implementations, only a switch device in one direct current combiner box is turned on, and it is determined that a wiring error occurs when another output voltage is detected as a negative voltage. This implementation is simple. In the second implementation, switch devices in at least two direct current combiner boxes are turned on, and it needs to be detected whether there is an output capacitor with a 0 voltage. In other words, when incorrect connection occurs, two ends of the output capacitor are short-circuited. As a result, a voltage of the short-circuited output capacitor is almost 0.

A specific location of the switch device in the direct current combiner box is not limited in this embodiment of this application, provided that the switch device is connected in series to the output capacitor, and charging and discharging of the output capacitor can be controlled through an action of the switch device. In a possible implementation, the switch device is connected in series between the input end and the output end of the direct current combiner box; and when the switch device is turned on, a photovoltaic string corresponding to the turned-on switch device charges an output capacitor connected in series to the turned-on switch device. It is assumed that the controller is further configured to determine that wiring of the M direct current combiner boxes is normal, that is, there is no wiring error, and energy of the photovoltaic string can be provided to the direct current bus. In this case, the controller controls and control switch devices in the M direct current combiner boxes to be turned on, where positive output ends and negative output ends of the M direct current combiner boxes are respectively connected to the direct current positive bus and the direct current negative bus.

In a possible implementation, to reduce impact of a large current at a moment when the photovoltaic string is connected to the direct current bus, and avoid impact on the output capacitor when the photovoltaic string is used to charge the output capacitor, a current-limiting resistor and a main switch are further included in the soft-start circuit. The current-limiting resistor is used to limit a current, so as to reduce impact of a large current, and protect the output capacitor. In addition, when it is detected that wiring is correct, the switch device may be controlled to be turned off, that is, the current-limiting resistor is disabled, thereby avoiding extra power consumption caused by a current flowing through the current-limiting resistor. The current-limiting resistor and the switch device are connected in series and then connected in parallel to the main switch. The main switch is connected in series between the input end and the output end of the direct current combiner box. The controller is configured to: control at least one switch device in the M direct current combiner boxes to be turned on, a remaining switch device to be turned off, and all the main switches to be turned off; and determine, based on voltages of output capacitors in all the soft-start circuits, whether a wiring error occurs in the M direct current combiner boxes. The controller is further configured to: determine that wiring of the M direct current combiner boxes is normal, and control the main switches in the M direct current combiner boxes to be turned on.

In this embodiment of this application, a form of a power supply that charges the output capacitor is not limited. For example, in the foregoing embodiments, the photovoltaic string may be used to charge the output capacitor. The following describes another implementation. For example, an internal power supply is disposed, and the output capacitor is charged through the internal power supply. In other words, in a possible implementation, the soft-start circuit further includes an internal power supply and a main switch. The main switch is connected in series between the input end and the output end of the direct current combiner box. The internal power supply and the switch device are connected in series and then connected in parallel to the output capacitor, and when the switch device is turned on, the internal power supply charges a corresponding output capacitor. The controller is configured to: control at least one switch device in the M direct current combiner boxes to be turned on, a remaining switch device to be turned off, and all the main switches to be turned off; and determine, based on voltages of output capacitors in all the soft-start circuits, whether a wiring error occurs in the M direct current combiner boxes. The controller is further configured to: determine that wiring of the M direct current combiner boxes is normal, and control the main switches in the M direct current combiner boxes to be turned on. The internal power supply may obtain power from an auxiliary power supply in the photovoltaic system in a magnetic field coupling manner, so that no other power supply needs to be disposed. This facilitates implementation.

In a possible implementation, to accurately detect a wiring error in the direct current combiner box, in addition to detecting the voltage on the output capacitor, the controller is further configured to determine that a wiring error occurs in the M direct current combiner boxes when an output current of the internal power supply is greater than a preset current value. The internal power supply is configured to charge the output capacitor. A larger current of the internal power supply indicates a higher voltage on the output capacitor. When the current of the internal power supply is greater than the preset current value, it indicates that the internal power supply outputs an excessively large current to charge the output capacitor. If the voltage on the output capacitor is not charged to a large value, it indicates that wiring is incorrect, and the output capacitor is not normally charged.

In a possible implementation, the output current of the internal power supply may be obtained by detecting a current of the following output resistor. The soft-start circuit further includes an output resistor. The output resistor, the switch device, and the internal power supply are all connected in series. The controller is specifically configured to determine that a wiring error occurs in the M direct current combiner boxes when a current of the output resistor is greater than the preset current value.

A specific implementation of the internal power supply is not limited in this embodiment of this application. For example, in a possible implementation, the internal power supply is a flyback power supply.

A location and a quantity of the controller are not limited in this embodiment of this application. For example, in a possible implementation, there are M controllers, the M controllers are in a one-to-one correspondence with the M direct current combiner boxes, and each controller is located inside a corresponding direct current combiner box. In other words, each direct current combiner box corresponds to a controller, and the controller only needs to detect a voltage of an output capacitor corresponding to the controller.

A specific connection manner of the soft-start circuit is not limited in this embodiment of this application. For example, the soft-start circuit is connected to the positive output end or the negative output end of the direct current combiner box, or the input end of the direct current combiner box.

In a possible implementation, the switch device is a semiconductor switch or a relay. The semiconductor switch may be an IGBT or a MOS.

The photovoltaic system provided in the embodiment of this application may be a photovoltaic energy storage system. For example, in a possible implementation, the photovoltaic system further includes an energy storage converter. The energy storage converter is configured to connect the direct current positive bus and the direct current negative bus. The energy storage converter may charge an energy storage battery by using energy on the direct current bus, or may release energy of an energy storage battery to the direct current bus. For example, energy storage batteries may be placed in an energy storage container.

Based on the photovoltaic system provided in the foregoing embodiments, an embodiment of this application further provides a direct current combiner box. Advantages of implementations of the photovoltaic system provided in the foregoing embodiments are applicable to the direct current combiner box and a method provided in the following embodiments. Details are not described herein again.

An input end of the direct current combiner box provided in this embodiment is configured to connect to a corresponding photovoltaic string, a positive output end and a negative output end of each of M direct current combiner boxes are respectively configured to connect to a direct current positive bus and a direct current negative bus, and M is an integer greater than or equal to 2. The direct current combiner box includes a soft-start circuit. The soft-start circuit includes at least a switch device and an output capacitor that are connected in series. The output capacitor is connected in parallel to the positive output end and the negative output end of the direct current combiner box. A switch device in at least one of the M direct current combiner boxes is turned on, an output capacitor connected in series to the turned-on switch device is charged, and a remaining switch device is turned off. Whether a wiring error occurs in the M direct current combiner boxes is determined based on voltages of output capacitors in at least some of the soft-start circuits.

In a possible implementation, a controller is further included. The controller is configured to: control a switch device in one of the M direct current combiner boxes to be turned on, and all remaining switch devices to be turned off; and when a voltage of at least one output capacitor in a remaining direct current combiner box is a negative voltage, determine that a wiring error occurs in the M direct current combiner boxes.

In a possible implementation, a controller is further included. The controller is configured to: control switch devices in at least two of the M direct current combiner boxes to be turned on, and all remaining switch devices to be turned off; and when a voltage of an output capacitor in a remaining direct current combiner box is less than a preset voltage value, determine that a wiring error occurs in the M direct current combiner boxes.

In a possible implementation, the switch device is connected in series between the input end and an output end of the direct current combiner box; and when the switch device is turned on, a photovoltaic string corresponding to the turned-on switch device charges an output capacitor connected in series to the turned-on switch device.

In a possible implementation, the soft-start circuit further includes a current-limiting resistor and a main switch; the current-limiting resistor and the switch device are connected in series and then connected in parallel to the main switch; and the main switch is connected in series between the input end and the output end of the direct current combiner box. The controller is configured to: control at least one switch device in the M direct current combiner boxes to be turned on, a remaining switch device to be turned off, and all the main switches to be turned off; and determine, based on voltages of output capacitors in all the soft-start circuits, whether a wiring error occurs in the M direct current combiner boxes.

In a possible implementation, the soft-start circuit further includes an internal power supply and a main switch. The main switch is connected in series between the input end and the output end of the direct current combiner box. The internal power supply and the switch device are connected in series and then connected in parallel to the output capacitor, and when the switch device is turned on, the internal power supply charges a corresponding output capacitor. The controller is configured to: control at least one switch device in the M direct current combiner boxes to be turned on, a remaining switch device to be turned off, and all the main switches to be turned off; and determine, based on voltages of output capacitors in all the soft-start circuits, whether a wiring error occurs in the M direct current combiner boxes.

Based on the photovoltaic system and the direct current combiner box that are provided in the foregoing embodiments, an embodiment of this application further provides a method for detecting a wiring error, applied to the photovoltaic system described above. The photovoltaic system includes M direct current combiner boxes and N inverters. Both M and N are integers greater than or equal to 2. Positive output ends and negative output ends of the M direct current combiner boxes are respectively configured to connect to a direct current positive bus and a direct current negative bus. An input end of each of the M direct current combiner boxes is configured to connect to a corresponding photovoltaic string. Positive input ends and negative input ends of the N inverters are respectively configured to connect the direct current positive bus and the direct current negative bus. Each of the M direct current combiner boxes includes a soft-start circuit. The soft-start circuit includes at least a switch device and an output capacitor that are connected in series. The output capacitor is connected in parallel to the positive output end and the negative output end of the direct current combiner box. The method includes: controlling a switch device in at least one of the M direct current combiner boxes to be turned on, an output capacitor connected in series to the turned-on switch device to be charged, and a remaining switch device to be turned off; and determining, based on voltages of output capacitors in at least some of the soft-start circuits, whether a wiring error occurs in the M direct current combiner boxes.

In a possible implementation, the controlling a switch device in at least one of the M direct current combiner boxes to be turned on, an output capacitor connected in series to the turned-on switch device to be charged, and a remaining switch device to be turned off specifically includes: controlling a switch device in one of the M direct current combiner boxes to be turned on, and all remaining switch devices to be turned off. The determining, based on voltages of output capacitors in all the soft-start circuits, whether a wiring error occurs in the M direct current combiner boxes specifically includes: when a voltage of at least one output capacitor in a remaining direct current combiner box is a negative voltage, determining that a wiring error occurs in the M direct current combiner boxes.

In a possible implementation, the controlling a switch device in at least one of the M direct current combiner boxes to be turned on, an output capacitor connected in series to the turned-on switch device to be charged, and a remaining switch device to be turned off specifically includes: controlling switch devices in at least two of the M direct current combiner boxes to be turned on, and all remaining switch devices to be turned off. The determining, based on voltages of output capacitors in all the soft-start circuits, whether a wiring error occurs in the M direct current combiner boxes specifically includes: if a voltage of an output capacitor in a remaining direct current combiner box is less than a preset voltage value, determining that a wiring error occurs in the M direct current combiner boxes.

This application has at least the following advantages:

According to the photovoltaic system provided in this embodiment of this application, a soft-start circuit is specifically added to the direct current combiner box. The soft-start circuit includes an output capacitor and a switch device that are connected in series. The output capacitor is connected in parallel to the positive output end and the negative output end of the direct current combiner box. Before the direct current combiner box is connected to the direct current bus, the switch device is turned on to charge the output capacitor. Then, a voltage on the output capacitor is measured to determine whether a wiring error occurs in one or more direct current combiner boxes. The photovoltaic system can quickly identify whether a wiring error occurs at the positive output end and the negative output end of the direct current combiner box. Because the output capacitor is connected in parallel to the output end of the direct current combiner box, when connections to the positive output end and the negative output end of the direct current combiner box are reversed, or a short circuit occurs between the positive output end or the negative output end of the direct current combiner box, a voltage on the output capacitor is caused to change. For example, when connections to the positive output end and the negative output end of the direct current combiner box are reversed, a voltage on the output capacitor is a negative voltage. When a short circuit occurs between the positive output end and the negative output end of the direct current combiner box, the output capacitor is short-circuited, and the voltage on the output voltage is almost 0. Therefore, in this embodiment of this application, whether a wiring error occurs in the direct current combiner box is determined by detecting the voltage on the output capacitor.

### BRIEF DESCRIPTION OF DRAWINGS

FIG. 1 is a schematic diagram of a structure of a photovoltaic system according to an embodiment of this application;
FIG. 2 is a schematic diagram of a structure of a photovoltaic system according to an embodiment of this application;
FIG. 3a is a schematic diagram of a structure of another photovoltaic system according to an embodiment of this application;
FIG. 3b is a flowchart of a method for detecting a wiring error according to an embodiment of this application;
FIG. 4a is a schematic diagram of a structure of a photovoltaic system with a wiring error according to an embodiment of this application;
FIG. 4b is a flowchart of another method for detecting a wiring error according to an embodiment of this application;
FIG. 4c is a schematic diagram of a structure of another photovoltaic system with a wiring error according to an embodiment of this application;
FIG. 4d is a schematic diagram of a structure of a photovoltaic system with correct wiring according to an embodiment of this application;
FIG. 5 is a schematic diagram of a structure of still another photovoltaic system with a wiring error according to an embodiment of this application;
FIG. 6 is a schematic diagram of a structure of yet another photovoltaic system with a wiring error according to an embodiment of this application;
FIG. 7a is a schematic diagram of a structure of still another photovoltaic system according to an embodiment of this application;
FIG. 7b is a flowchart of still another method for detecting a wiring error according to an embodiment of this application;
FIG. 8a is a schematic diagram of a structure of still another photovoltaic system according to an embodiment of this application;
FIG. 8b is a schematic diagram of a structure of still yet another photovoltaic system with a wiring error according to an embodiment of this application;
FIG. 9 is a flowchart of yet another method for detecting a wiring error according to an embodiment of this application;
FIG. 10a is a flowchart of still yet another method for detecting a wiring error according to an embodiment of this application;
FIG. 10b is a diagram of a structure of a further photovoltaic system with a wiring error according to an embodiment of this application;
FIG. 11 is a schematic diagram of a structure of yet another photovoltaic system according to an embodiment of this application;
FIG. 12 is a schematic diagram of a structure of a still further photovoltaic system with a wiring error according to an embodiment of this application;
FIG. 13 is a flowchart of a further method for detecting a wiring error according to an embodiment of this application;
FIG. 14 is a flowchart of a still further method for detecting a wiring error according to an embodiment of this application;
FIG. 15 is a diagram of a structure of a yet further photovoltaic system with a wiring error according to an embodiment of this application; and
FIG. 16 is a schematic diagram of a direct current combiner box according to an embodiment of this application.

### DESCRIPTION OF EMBODIMENTS

The following describes technical solutions in embodiments of this application with reference to accompanying drawings in embodiments of this application.

The following terms "first", "second", and the like are merely intended for a purpose of description, and shall not be understood as an indication or implication of relative importance or implicit indication of a quantity of indicated technical characteristics. Therefore, a feature limited by "first ", "second" and the like may explicitly indicate or implicitly include one or more such features. In description of this application, unless otherwise stated, "plurality" means two or more than two.

In this application, unless otherwise specified and limited, the term "connection" should be understood in a broad sense. For example, the "connection" may be a fixed connection, a detachable connection, an integration, a direct connection, or an indirect connection via an intermediate medium. In addition, a term "coupling" may be a manner of implementing an electrical connection for signal transmission. The "coupling" may be a direct electrical connection, or may be an indirect electrical connection via an intermediate medium.

Embodiments of this application relate to a photovoltaic system. An example in which the photovoltaic system includes a direct current combiner box, an inverter, and a direct current bus is used for description. Generally, there are a plurality of direct current combiner boxes, and output ends of the plurality of direct current combiner boxes are all connected to the direct current bus. To enable a person skilled in the art to better understand the technical solutions provided in embodiments of this application, the following accompanying drawings describe a photovoltaic system provided in embodiments of this application.

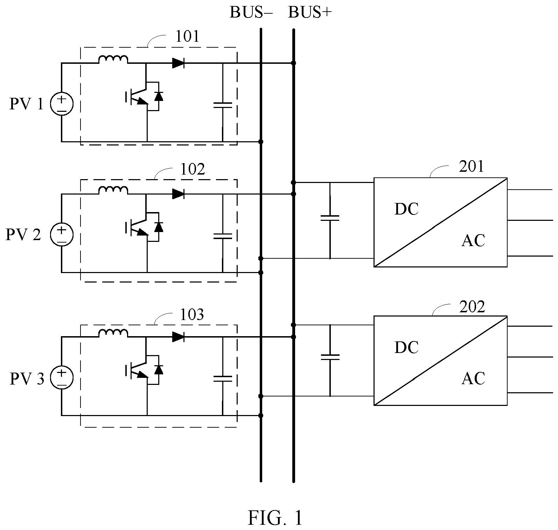

FIG. 1 is a schematic diagram of a structure of a photovoltaic system according to an embodiment of this application.

The photovoltaic system provided in this embodiment includes a plurality of direct current combiner boxes and a plurality of inverters. In actual application, a quantity of direct current combiner boxes and a quantity of inverters included in the photovoltaic system are not limited. The photovoltaic system may include M direct current combiner boxes and N inverters. M and N are both positive integers, and M and N may be unequal positive integers, or may be equal positive integers.

For ease of understanding and description, as shown in FIG. 1, the photovoltaic system provided in this embodiment of this application including three direct current combiner boxes and two inverters is used as an example for description. As shown in FIG. 1, a direct current combiner box in the photovoltaic system provided in this embodiment of this application may include a direct current/direct current (DC/DC, Direct Current/Direct Current) circuit. The DC/DC circuit may be a boost circuit, a buck-boost circuit, or the like. An example in which the DC/DC circuit is a boost circuit is used in the figure for description. Specifically, the DC/DC circuit is a Boost (boost) circuit in the figure. In actual application, the direct current combiner box may be a two-level, three-level, or another form of boost circuit, or may be a buck circuit or a buck-boost circuit. This is not limited in this embodiment of this application. The inverter in this embodiment of this application may also be of a two-level structure, a multi-level structure, or another single-phase or multi-phase topology structure.

The photovoltaic system provided in this embodiment of this application includes a first direct current combiner box 101, a second direct current combiner box 102, a third direct current combiner box 103, a first inverter 201, and a second inverter 202. Input ends of the first direct current combiner box 101, the second direct current combiner box 102, and the third direct current combiner box 103 are respectively connected to a photovoltaic string PV 1, a photovoltaic string PV 2, and a photovoltaic string PV 3. The photovoltaic string is merely used as an example herein. In an actual product, the photovoltaic string PV-PV 3 may include a plurality of photovoltaic strings, that is, an input end of each direct current combiner box is connected to a plurality of photovoltaic strings. In addition, the figure merely shows that each direct current combiner box includes one boost circuit. In an actual product, each direct current combiner box may include a plurality of boost circuits connected in parallel. Positive output ends and negative output ends of the first direct current combiner box 101, the second direct current combiner box 102, and the third direct current combiner box 103 are respectively connected to a direct current positive bus BUS+ and a direct current negative bus BUS-. Positive input ends and negative input ends of the first inverter 201 and the second inverter 202 are respectively connected to the direct current positive bus BUS+ and the direct current negative bus BUS-. The direct current positive bus BUS+ and the direct current negative bus BUS- are collectively referred to as a direct current bus.

It may be understood that, in this embodiment of this application, PV 1, PV 2, and PV 3 are respectively connected to the input ends of corresponding direct current combiner boxes, and the output ends of the direct current combiner boxes are connected in parallel to the direct current bus. The inverter 201 and the inverter 202 separately invert a direct current on the direct current bus into an alternating current, and feed back the alternating current to an alternating current power grid or provide the alternating current to an electrical device.

Because the output ends of the plurality of direct current combiner boxes are all connected in parallel to the direct current bus, a wiring error may occur between the direct current bus and positive output ends and negative output ends of one or more direct current combiner boxes, which causes a short circuit or another serious fault of the entire direct current bus. Therefore, the photovoltaic system provided in this embodiment of this application can quickly identify whether a wiring error exists at the positive output end and the negative output end of the direct current combiner box. Specifically, a soft-start circuit is added to the direct current combiner box. The soft-start circuit includes an output capacitor and a switch device that are connected in series. The output capacitor is connected in parallel to the positive output end and the negative output end of the direct current combiner box. Before the direct current combiner box is connected to the direct current bus, the switch device is turned on to charge the output capacitor. Then, a voltage on the output capacitor is measured to determine whether a wiring error occurs in one or more direct current combiner boxes. Because the output capacitor is connected in parallel to the output end of the direct current combiner box, when connections to the positive output end and the negative output end of the direct current combiner box are reversed, or a short circuit occurs between the positive output end or the negative output end of the direct current combiner box, a voltage on the output capacitor is caused to change. For example, when connections to the positive output end and the negative output end of the direct current combiner box are reversed, a voltage on the output capacitor is a negative voltage. When a short circuit occurs between the positive output end and the negative output end of the direct current combiner box, the output capacitor is short-circuited, and the voltage on the output voltage is 0. Therefore, in this embodiment of this application, whether a wiring error occurs in the direct current combiner box is determined by detecting the voltage on the output capacitor.

The following describes in detail the photovoltaic system provided in embodiments of this application with reference to the accompanying drawings. For ease of understanding, the following photovoltaic system embodiments are described with reference to embodiments of a method for detecting a wiring error. The method embodiments are not described separately.

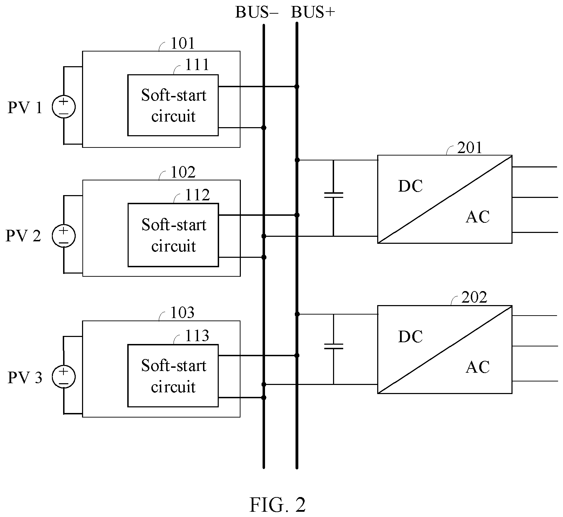

FIG. 2 is a schematic diagram of another photovoltaic system according to an embodiment of this application.

The photovoltaic system provided in this embodiment of this application is described by still using an example in which the photovoltaic system includes three direct current combiner boxes and two inverters. In other words, the photovoltaic system provided in this embodiment of this application includes a first direct current combiner box 101, a second direct current combiner box 102, a third direct current combiner box 103, a first inverter 201, and a second inverter 202.

Positive output ends and negative output ends of M direct current combiner boxes are respectively configured to connect to a direct current positive bus BUS+ and a direct current negative bus BUS-. An input end of each of the M direct current combiner boxes is configured to connect to a corresponding photovoltaic string. Positive input ends and negative input ends of the N inverters are respectively configured to connect the direct current positive bus and the direct current negative bus. For example, input ends of the first direct current combiner box 101, the second direct current combiner box 102, and the third direct current combiner box 103 are respectively connected to a photovoltaic string PV 1, a photovoltaic string PV 2, and a photovoltaic string PV 3. Positive output ends and negative output ends of the first direct current combiner box 101, the second direct current combiner box 102, and the third direct current combiner box 103 are respectively connected to the direct current positive bus BUS+ and the direct current negative bus BUS-. Positive input ends and negative input ends of the first inverter 201 and the second inverter 202 are respectively connected to the direct current positive bus BUS+ and the direct current negative bus BUS-.

Each of the M direct current combiner boxes includes a soft-start circuit. The soft-start circuit includes at least a switch device and an output capacitor that are connected in series, and the output capacitor is connected in parallel to the positive output end and the negative output end of the direct current combiner box. In an example, the direct current combiner box in this embodiment of this application may have a maximum power point tracking (MPPT, Maximum Power Point Tracking) function.

The first direct current combiner box 101, the second direct current combiner box 102, and the third direct current combiner box 103 respectively include a first soft-start circuit 111, a second soft-start circuit 112, and a third soft-start circuit 113. Each of the first soft-start circuit 111, the second soft-start circuit 112, and the third soft-start circuit 113 includes a switch device and an output capacitor that are connected in series, and the output capacitor is connected in parallel to a positive output end and a negative output end of a corresponding direct current combiner box.

When it needs to be detected whether a wiring error exists in the direct current combiner box, a switch device in at least one of the M direct current combiner boxes is turned on, and a switch device in a remaining direct current combiner box may be turned off. In an example, a switch device in the first soft-start circuit 111 is turned on, and switch devices in the second soft-start circuit 112 and the third soft-start circuit 113 are both turned off. In this case, an output capacitor connected in series to the turned-on switch device is charged, that is, an output capacitor connected between the direct current buses in the first soft-start circuit 111 is charged. Output capacitors in the second soft-start circuit 112 and the third soft-start circuit 113 are connected to the direct current buses through output ends of the direct current combiner boxes to be charged. Therefore, whether a wiring error occurs in the M direct current combiner boxes may be determined based on voltages of output capacitors in all the soft-start circuits.

In this example, the output capacitors in the first soft-start circuit 111, the second soft-start circuit 112, and the third soft-start circuit 113 each are connected in parallel to a positive output end and a negative output end of a corresponding direct current combiner box. In other words, the output capacitors in the first soft-start circuit 111, the second soft-start circuit 112, and the third soft-start circuit 113 are connected in parallel through the direct current positive bus and the direct current negative bus. When the output capacitor in the first soft-start circuit 111 is charged, the output capacitors in the second soft-start circuit 112 and the third soft-start circuit 113 are also charged through the direct current positive bus and the direct current negative bus. Because the output capacitors in the second soft-start circuit 112 and the third soft-start circuit 113 are connected in parallel to the output ends of the direct current combiner boxes, when a wiring error occurs between the direct current bus and the output ends of one or more of the direct current combiner box 101, the direct current combiner box 102, and the direct current combiner box 103, voltages on the output capacitors in the second soft-start circuit 112 and the third soft-start circuit 113 are abnormal. For example, when the second soft-start circuit 112 is reversely connected to the direct current buses, that is, when the output end of the second soft-start circuit 112 of the direct current combiner box is reversely connected to the direct current buses, because the output capacitor of the second soft-start circuit 112 is connected in parallel to the output end of the direct current combiner box, a voltage on the output capacitor of the second soft-start circuit 112 is a negative voltage.

In this embodiment of this application, when a wiring error occurs in one or more of the M direct current combiner boxes, voltages of some or all of the output capacitors in all the soft-start circuits are abnormal. In this case, it can be determined that a wiring error occurs in the one or more direct current combiner boxes.

In this embodiment of this application, voltages on output capacitors in at least some soft-start circuits are detected to determine whether a wiring error occurs. For example, voltages on the output capacitors in all the soft-start circuits may be detected. Alternatively, voltages on output capacitors in some soft-start circuits may be detected, because once a wiring error occurs, a voltage on an output capacitor in another direct current combiner box is affected. A quantity of detected soft-start circuits is not specifically limited in this embodiment of this application. A person skilled in the art may set the quantity of detected soft-start circuits based on an actual requirement, provided that a wiring fault can be determined by detecting a voltage on an output capacitor.

In conclusion, in the photovoltaic system provided in this embodiment of this application, the soft-start circuit is added to the direct current combiner box. Before the direct current combiner box is connected to the direct current bus, a switch device in the soft-start circuit is turned on to charge an output capacitor. In this way, it can be determined, by detecting a voltage of the output capacitor, whether an error exists in the combiner box. In the photovoltaic system provided in this embodiment of this application, it can be detected whether a wiring error occurs in the direct current combiner box, including whether a wiring error occurs in one direct current combiner box and whether a wiring error occurs in a plurality of direct current combiner boxes.

The soft-start circuit provided in embodiments of this application includes at least a switch device and an output capacitor. A specific implementation of the switch device is not limited. For example, the switch device may be a relay, a contactor, a circuit breaker, or a semiconductor switch device. The semiconductor switch device may be an insulated gate bipolar transistor (IGBT, Insulated Gate Bipolar Transistor), a MOSFET metal-oxide-semiconductor field-effect transistor (MOS, Metal-Oxide-Semiconductor Field-Effect Transistor), or the like.

For ease of description, the following embodiments are described by using an example in which the switch device is a relay. When the switch device in the soft-start circuit provided in embodiments of this application is turned on, an output capacitor is charged. It may be understood that the soft-start circuit provided in embodiments of this application is merely used to detect whether a wiring error occurs in a direct current combiner box. After detection is completed, the soft-start circuit is disabled, that is, the switch device in the soft-start circuit remains a turned-off state.

In the photovoltaic system provided in embodiments of this application, a charging manner of the output capacitor is not limited. For example, the output capacitor may be charged by using a power supply in the soft-start circuit, or the output capacitor may be charged by using a power supply outside the soft-start circuit. The following first describes an implementation in which the soft-start circuit includes an internal power supply, and the output capacitor is charged by using the internal power supply, to detect whether a wiring error occurs in the direct current combiner box.

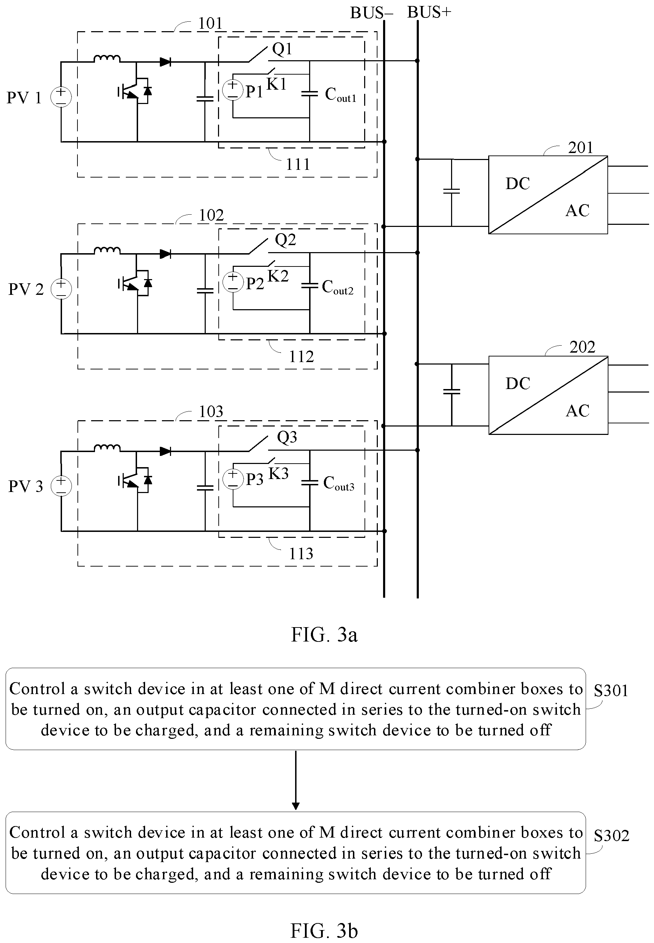

FIG. 3a is a schematic diagram of still another photovoltaic system according to an embodiment of this application.

A soft-start circuit provided in this embodiment of this application may further include an internal power supply and a main switch. The main switch is connected in series between an input end and an output end of a direct current combiner box.

As shown in FIG. 3a, in this embodiment of this application, a photovoltaic system including three direct current combiner boxes and two inverters is still used as an example for description.

A first soft-start circuit 111 provided in this embodiment of this application includes a first internal power supply P1, a first main switch Q1, a first switch device K1, and a first output capacitor Cout1. After being connected in series to the first switch device K1, the first internal power supply P1 is connected in parallel to two ends of the first output capacitor Cout1. A first end of the first output capacitor Cout1 is connected to a direct current positive bus BUS+, and is connected to another component in the direct current combiner box through the first main switch Q1. A second end of the first output capacitor Cout1 is connected to both a direct current negative bus BUS- and another component in the direct current combiner box.

A second soft-start circuit 112 provided in this embodiment of this application includes a second internal power supply P2, a second main switch Q2, a second switch device K2, and a second output capacitor Cout2. After being connected in series to the second switch device K2, the second internal power supply P2 is connected in parallel to two ends of the second output capacitor Cout2. A first end of the second output capacitor Cout2 is connected to the direct current positive bus BUS+, and is connected to another component in the direct current combiner box through the second main switch Q2. A second end of the second output capacitor Cout2 is connected to both the direct current negative bus BUS- and another component in the direct current combiner box.

A third soft-start circuit 113 provided in this embodiment of this application includes a third internal power supply P3, a third main switch Q3, a third switch device K3, and a third output capacitor Cout3. After being connected in series to the third switch device K3, the third internal power supply P3 is connected in parallel to two ends of the third output capacitor Cout3. A first end of the third output capacitor Cout3 is connected to the direct current positive bus BUS+, and is connected to another component in the direct current combiner box through the third main switch Q3. A second end of the third output capacitor Cout3 is connected to both the direct current negative bus BUS- and another component in the direct current combiner box.

In this embodiment of this application, the internal power supply and the switch device are connected in series and then connected in parallel to the output capacitor. When correctness of wiring of the direct current combiner box needs to be detected, the main switch is turned off, the switch device is turned on, and the internal power supply charges the corresponding output capacitor. In an example, the first internal power supply P1 and the first switch device K1 are connected in series and then connected in parallel to the first output capacitor Cout1. When correctness of wiring of the direct current combiner box needs to be detected, in a possible implementation, the first main switch Q1 may be turned off, the first switch device K1 may be turned on, and the first internal power supply P1 charges the first output capacitor Cout1 through the first switch device K1.

After detection is completed, if no wiring error is found, all the main switches are turned on. Photovoltaic strings start to output a current to the direct current bus, and the photovoltaic system enters a normal operation state. For example, in the foregoing example, when no wiring error is found, the first main switch Q1, the second main switch Q2, and the third main switch Q3 may be turned on, and the photovoltaic strings PV 1 to PV 3 start to output a current to the direct current bus.

Considering that the soft-start circuit may consume an output power of the photovoltaic system, in a possible implementation in this embodiment of this application, when the main switch is turned on, the switch device may be turned off, to avoid impact of the soft-start circuit on a normal operation state of the photovoltaic system. For example, in the foregoing example, when the first main switch Q1, the second main switch Q2, and the third main switch Q3 are turned on, the first switch device K1 may be turned off, to prevent the first soft-start circuit from affecting normal running of the photovoltaic system.

In this embodiment of this application, a type and a source of the internal power supply are not limited. For example, the internal power supply may be a flyback power supply, or may be another type of power supply. In a possible implementation, the internal power supply in this embodiment may obtain power from the photovoltaic string in a form of electromagnetic coupling. For example, a power supply is connected through coupling between a primary winding and a secondary winding of a transformer. The primary winding of the transformer is connected to the photovoltaic string, and the secondary winding is used as a source of the internal power supply. For example, the first internal power supply P1 may obtain a voltage through the photovoltaic string PV 1.

To control an on/off status of the switch device in the soft-start circuit, the photovoltaic system provided in this embodiment of this application may further include a controller (which is not shown in the figure).

In a possible implementation, the controller may be configured to: control a switch device in one of the M direct current combiner boxes to be turned on, and all remaining switch devices to be turned off; and when a voltage of at least one output capacitor in a remaining direct current combiner box is a negative voltage, determine that a wiring error occurs in the M direct current combiner boxes. For example, the first switch device K1 is controlled to be turned on, and both the second switch device K2 and the third switch device K3 are turned off. Therefore, the first internal power supply P1 charges the first output capacitor Cout1, and the second output capacitor Cout2 and the third output capacitor Cout3 are connected in parallel to the first output capacitor Cout1 through the direct current bus. Therefore, the first internal power supply P1 also charges the second output capacitor Cout2 and the third output capacitor Cout3.

In this embodiment of this application, to detect whether wiring of a direct current combiner box is incorrect, a method for detecting a wiring error is further provided. The method is applied to the foregoing photovoltaic system.

FIG. 3b is a flowchart of a method for detecting a wiring error according to an embodiment of this application.

The method for detecting a wiring error provided in this embodiment of this application includes the following steps.

S301: Control a switch device of at least one of the M direct current combiner boxes to be turned on, an output capacitor connected in series to the turned-on switch device to be charged, and a remaining switch device to be turned off.

S302: Determine, based on voltages of output capacitors in all soft-start circuits, whether a wiring error occurs in the M direct current combiner boxes.

As shown in FIG. 3a, when all the direct current combiner boxes are correctly connected to the direct current bus, a voltage of the first output capacitor Cout1, a voltage of the second output capacitor Cout2, and a voltage of the third output capacitor Cout3 are all positive voltages. When determining that wiring of the M direct current combiner boxes is normal, the controller may control main switches in the M direct current combiner boxes to be turned on, so that the photovoltaic system in this embodiment of this application supplies power to a power grid or an electrical device. In other words, when the voltage of the first output capacitor Cout1, the voltage of the second output capacitor Cout2, and the voltage of the third output capacitor Cout3 are all positive voltages, the controller determines that wiring of the first direct current combiner box 101, the second direct current combiner box 102, and the third direct current combiner box 103 is normal. In this case, the controller may control the first main switch Q1, the second main switch Q2, and the third main switch Q3 to be all turned on, so that the photovoltaic string transmits a current to the direct current bus, and the photovoltaic system supplies power to the power grid or the electrical device.

It can be learned that, when wiring of all the direct current combiner boxes in the photovoltaic system is normal, in the solution provided in this embodiment of this application, it may be measured that voltages on all output capacitors are positive voltages, so that it is determined that wiring of all the direct current combiner boxes in the photovoltaic system is normal in this case.

In this embodiment of this application, a plurality of incorrect wiring cases may occur when the direct current combiner box is connected to the direct current bus. To make the solution provided in this embodiment of this application better understood, the following first uses a reverse connection of the third direct current combiner box 103 as an embodiment to describe a wiring error in the direct current combiner box.

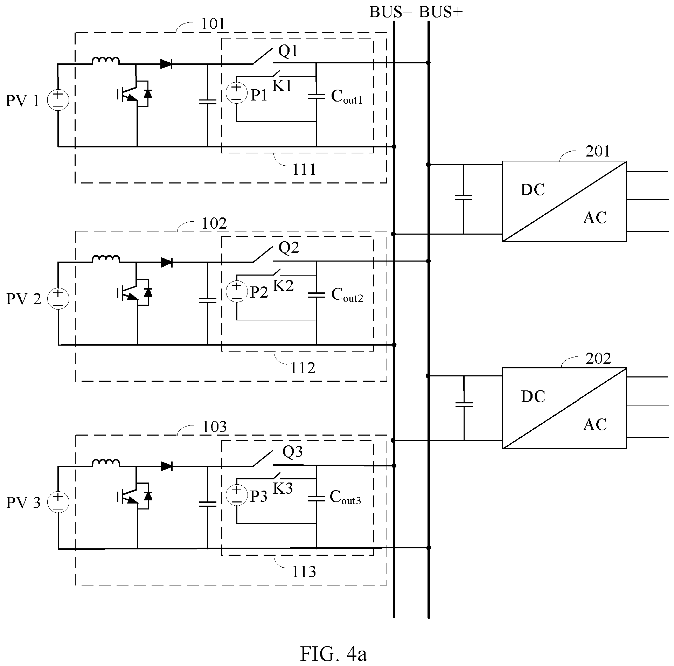

FIG. 4a is a schematic diagram of a structure of a photovoltaic system with a wiring error according to an embodiment of this application.

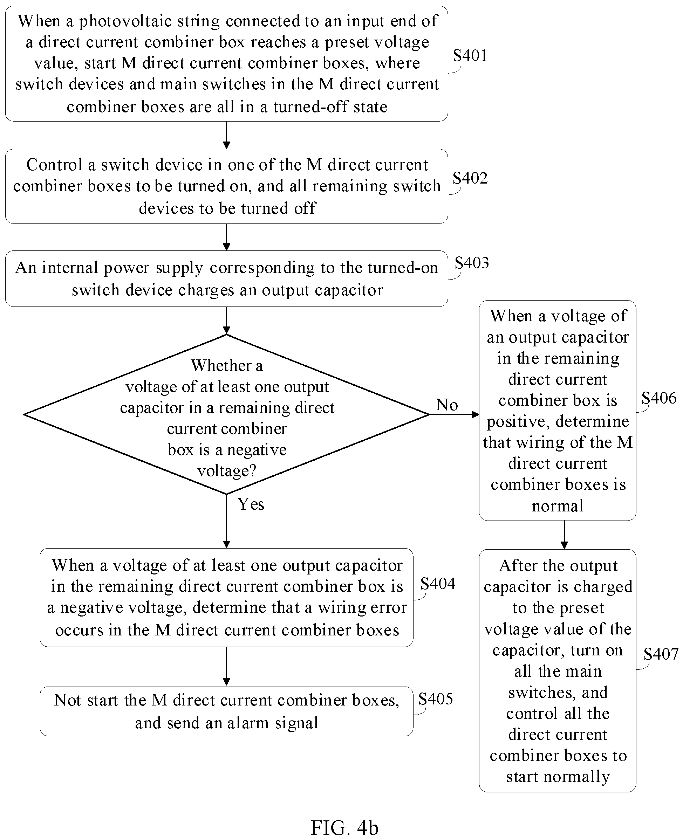

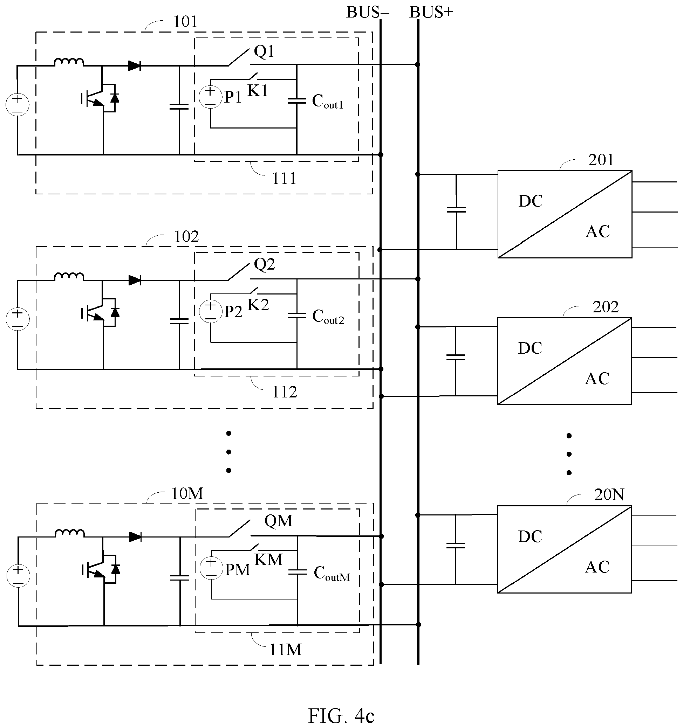

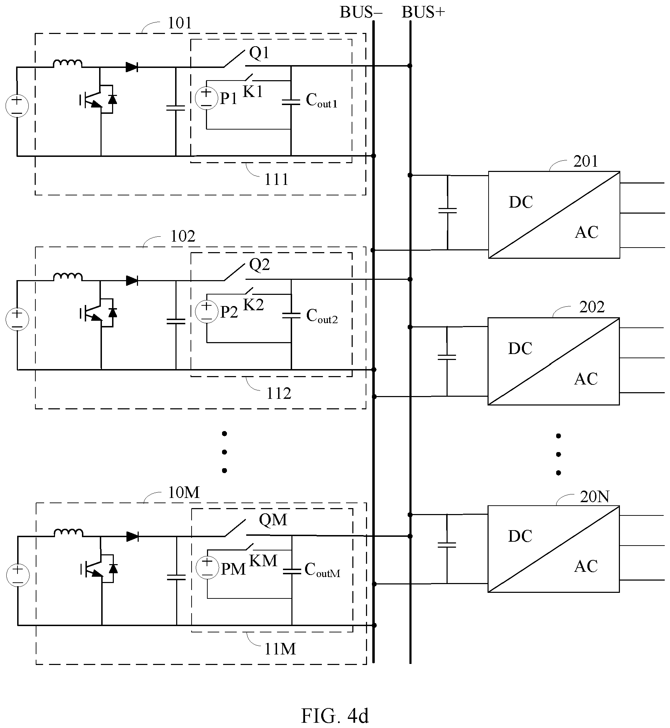

If wiring of a direct current combiner box is normal, positive output ends of all direct current combiner boxes are connected to a direct current positive bus, and negative output ends of all the direct current combiner boxes are connected to a direct current negative bus. As shown in FIG. 4, a positive output end of a third direct current combiner box 103 is connected to the direct current negative bus, and a negative output end is connected to the direct current positive bus, that is, the third direct current combiner box 103 is reversely connected to the direct current buses.

An output capacitor in the direct current combiner box is connected in parallel to a positive output end and a negative output end of a corresponding direct current combiner box. When a first switch device K1 is controlled to be turned on, and both a second switch device K2 and a third switch device K3 are turned off, because the third direct current combiner box 103 is reversely connected to the direct current buses, and both a first direct current combiner box 101 and a second direct current combiner box are positively connected to the direct current buses, a voltage on a third output capacitor Cout3 in the third direct current combiner box 103 is opposite to a voltage on the first output capacitor Cout1 and a voltage on the second output capacitor Cout2, and is a negative voltage. In this case, it may be determined that a wiring error occurs in the direct current combiner box in the photovoltaic system.

In this embodiment of this application, to detect whether wiring of the direct current combiner box is incorrect, a method for detecting a wiring error is further provided. The method is applied to the foregoing photovoltaic system. The method specifically includes: controlling a switch device in one of the M direct current combiner boxes to be turned on, and all remaining switch devices to be turned off; and when a voltage of at least one output capacitor in a remaining direct current combiner box is a negative voltage, determining that a wiring error occurs in the M direct current combiner boxes. The following describes, by using specific embodiments, specific application manners in which the method is applied to the photovoltaic system in embodiments of this application.

FIG. 4b is a flowchart of another method for detecting a wiring error according to an embodiment of this application.

FIG. 4c is a schematic diagram of a structure of another photovoltaic system with a wiring error according to an embodiment of this application.

FIG. 4d is a schematic diagram of a structure of a photovoltaic system with correct wiring according to an embodiment of this application.

With reference to FIG. 4b to FIG. 4d, the following describes a method for detecting a wiring error according to an embodiment of this application. The method includes the following steps:
S401: When a photovoltaic string connected to an input end of a direct current combiner box reaches a preset voltage value, start M direct current combiner boxes, where switch devices and main switches in the M direct current combiner boxes are all in a turned-off state.

In a possible implementation, as shown in FIG. 4c, direct current combiner boxes 101 to 10M in this embodiment of this application are started, switch devices K1 to KM are all turned off, and main switches Q1 to QM are all turned off.

S402: Control a switch device in one of the M direct current combiner boxes to be turned on, and all remaining switch devices to be turned off.

In an example, the first switch device K1 in the first direct current combiner box 101 may be controlled to be turned on, and the switch devices K2 to KM in the remaining direct current combiner boxes 102 to 10M are all turned off.

S403: An internal power supply corresponding to the turned-on switch device charges an output capacitor.

In other words, when the first switch device K1 is turned on, a first internal power supply P1 corresponding to the first switch device K1 charges an output capacitor Cout1. In a normal case, two ends of each of output capacitors Cout1 to CoutM are respectively connected between a direct current positive bus BUS+ and a direct current negative bus BUS-. In other words, in a normal case, the output capacitors Cout1 to CoutM are all connected in parallel. When the first internal power supply P1 charges the first output capacitor Cout1, a voltage on Cout1 affects a voltage of another output capacitor, that is, voltages of other output capacitors Cout2 to CoutM should be consistent with the voltage of Cout1.

S404: When a voltage of at least one output capacitor in a remaining direct current combiner box is a negative voltage, determine that a wiring error occurs in the M direct current combiner boxes.

As shown in FIG. 4c, a reverse connection of the M^{th} direct current combiner box 10M is used as an example. Because a positive output end of the M* direct current combiner box 10M is connected to the direct current negative bus BUS-, and a negative output end of the M^{th} direct current combiner box 10M is connected to the direct current positive bus BUS+. Because a first end of the M^{th} output capacitor CoutM is connected to the positive output end of the M^{th} direct current combiner box 10M, and a second end of the M^{th} output capacitor CoutM is connected to the negative output end of the M^{th} direct current combiner box 10M, the first end of the M^{th} output capacitor CoutM is connected to the direct current negative bus BUS-, and the second end of the M* output capacitor CoutM is connected to the direct current positive bus BUS+. A first end of the first output capacitor Cout1 is connected to the direct current positive bus BUS+, and a second end of the first output capacitor Cout1 is connected to the direct current negative bus BUS-. As a result, a voltage of the M^{th} output capacitor CoutM is opposite to a voltage of the first output capacitor Cout1, that is, the voltage of the M* output capacitor CoutM is negative. Therefore, it is determined that a wiring error occurs in the M direct current combiner boxes.

S405: Not start power circuits of the M direct current combiner boxes, and send an alarm signal.

In other words, power circuits of the direct current combiner boxes 101 to 10M are not started, the main switches Q1 to QM are kept turned-off, and an alarm signal is sent. In an example, in the solution provided in this application, the alarm signal may be sent to a monitoring board, to give an alarm to the external.

S406: When a voltage of an output capacitor in the remaining direct current combiner box is positive, determine that wiring of the M direct current combiner boxes is normal.

As shown in FIG. 4d, that wiring of the M direct current combiner boxes is correct is used as an example. Positive output ends of the direct current combiner boxes 102 to 10M are connected to the direct current positive bus BUS+, the negative output end of the M^{th} direct current combiner box 10M is connected to the direct current negative bus BUS-, first ends of the output capacitors Cout2 to CoutM are all connected to the direct current positive bus BUS+, and second ends of the output capacitors Cout2 to CoutM are all connected to the direct current positive bus BUS-. Therefore, voltages of the output capacitors Cout2 to CoutM are all positive, so that it is determined that wiring of the M direct current combiner boxes is correct.

S407: After the output capacitor is charged to the preset voltage value of the capacitor, turn on all the main switches, and control all the direct current combiner boxes to start normally.

In other words, to reduce impact of the output capacitor on the photovoltaic system in normal operation, after the output capacitors Cout1 to CoutM are charged to preset voltage values of the capacitors, the main switches Q1 to QM are turned on, and the power circuits of the direct current combiner boxes 101 to 10M are controlled to start, and the direct current combiner boxes 101 to 10M are normally started.

It can be learned that, when a direct current combiner box is reversely connected in the photovoltaic system, in the solution provided in this embodiment of this application, it may be measured that a voltage on an output capacitor is a negative voltage, so that it is determined that a wiring error occurs in the direct current combiner box in the photovoltaic system in this case.

The following, by using a case in which the third direct current combiner box is short-circuited as an embodiment, continues to describe incorrect wiring cases of the direct current combiner box.

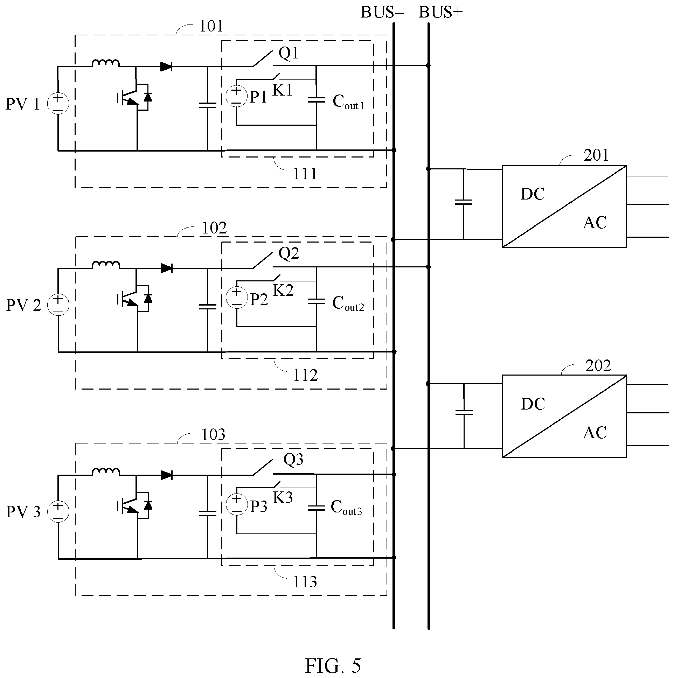

FIG. 5 is a schematic diagram of a structure of still another photovoltaic system with a wiring error according to an embodiment of this application.

As shown in FIG. 5, an output capacitor in a direct current combiner box is connected in parallel to a positive output end and a negative output end of the direct current combiner box corresponding to the output capacitor. When a first switch device K1 is controlled to be turned on, and a second switch device K2 and a third switch device K3 are controlled to be turned off, because a third direct current combiner box 103 is short-circuited, a voltage on a third output capacitor Cout3 in the third direct current combiner box is close to 0 V. In this case, it may also be determined that a wiring error occurs in the direct current combiner box in the photovoltaic system.

It can be learned that, when a direct current combiner box is short-circuited in the photovoltaic system, in the solution provided in this embodiment of this application, it may be measured that a voltage on an output capacitor is close to 0 V, so that it is determined that a wiring error occurs in the direct current combiner box in the photovoltaic system in this case.

In conclusion, a controller provided in this embodiment of this application may determine, based on voltage values of M output capacitors after controlling a switch device in one of M direct current combiner boxes to be turned on, whether a wiring error occurs in the M direct current combiner boxes.

In another possible implementation, the controller may be further configured to: control switch devices in at least two of the M direct current combiner boxes to be turned on, and all remaining switch devices to be turned off; and when a voltage of an output capacitor in a remaining direct current combiner box is less than a preset voltage value, determine that a wiring error occurs in the M direct current combiner boxes. For example, the first switch device K1 and the second switch device K2 are controlled to be turned on, and the third switch device K3 is controlled to be turned off.

As shown in FIG. 3, when all the direct current combiner boxes are correctly connected to the direct current bus, a voltage of a first output capacitor Cout1, a voltage of a second output capacitor Cout2, and a voltage of a third output capacitor Cout3 are all positive voltages, and are greater than the preset voltage value. When determining that wiring of the M direct current combiner boxes is normal, the controller may control main switches in the M direct current combiner boxes to be turned on, so that the photovoltaic system in this embodiment of this application supplies power to a power grid or an electrical device.

To make the solution provided in this embodiment of this application better understood, the following uses a reverse connection of a second direct current combiner box as an embodiment to describe a principle of detecting a wiring error in the solution in this embodiment of this application.

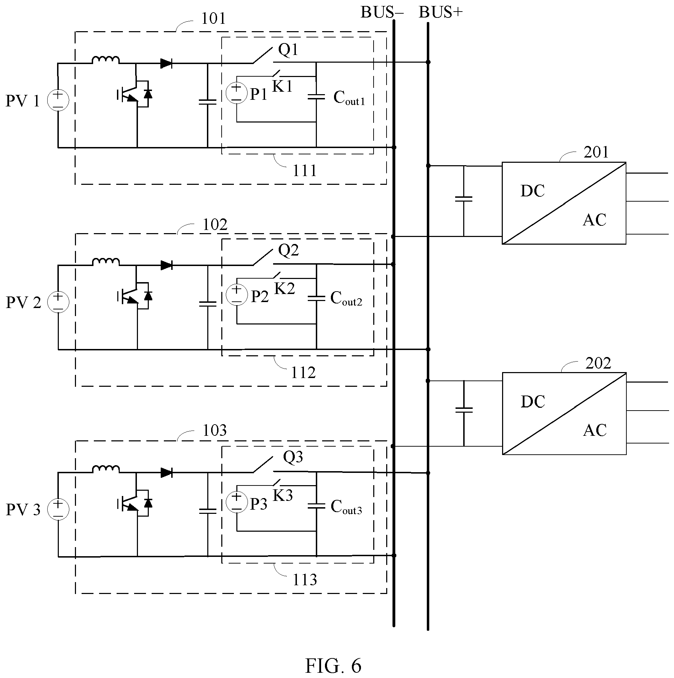

FIG. 6 is a schematic diagram of a structure of yet another photovoltaic system with a wiring error according to an embodiment of this application.

If wiring of a direct current combiner box is normal, positive output ends of all direct current combiner boxes are connected to a direct current positive bus, and negative output ends of all the direct current combiner boxes are connected to a direct current negative bus. As shown in FIG. 6, a second direct current combiner box 102 is reversely connected to the direct current bus. When a first switch device K1 and a second switch device K2 are controlled to be turned on, and a third switch device K3 is controlled to be turned off, a first internal power supply P1 and a second internal power supply P2 are short-circuited. As a result, a voltage of an output capacitor Cout3 in a third direct current combiner box 103 is less than a preset voltage value. In an example, the preset voltage value may be close to 0 V.

To reduce power consumption during voltage detection, an embodiment of this application further provides a soft-start circuit with an output resistor.

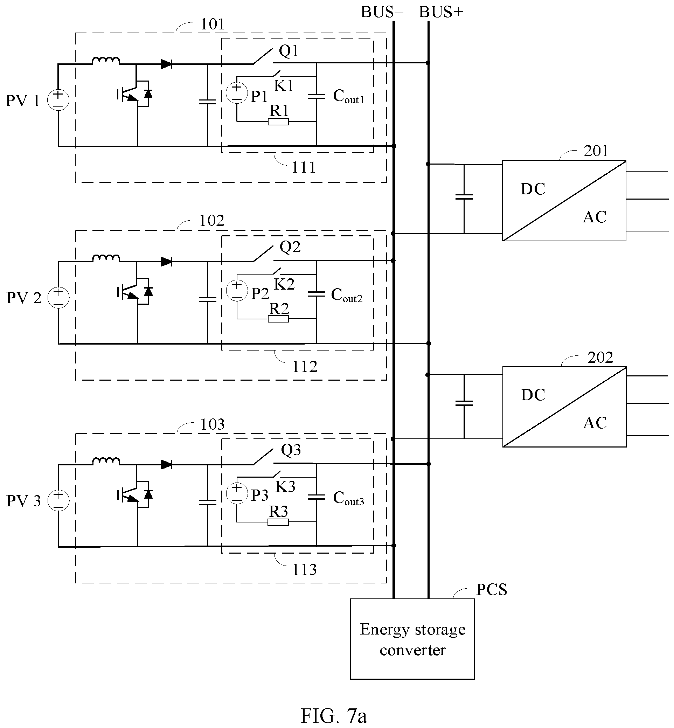

FIG. 7a is a schematic diagram of a structure of still another photovoltaic system according to an embodiment of this application.

In a possible implementation, a soft-start circuit provided in this embodiment of this application may further include an output resistor. The output resistor, a switch device, and an internal power supply are all connected in series. As shown in FIG. 7a, in this embodiment of this application, a photovoltaic system including three direct current combiner boxes and two inverters is still used as an example for description. In other words, a first soft-start circuit 111 provided in this embodiment of this application includes a first output resistor R1, a second soft-start circuit 112 provided in this embodiment of this application includes a second output resistor R2, and a third soft-start circuit 113 provided in this embodiment of this application includes a third output resistor R3.

The first output resistor R1, a first switch device K1, and a first internal power supply P1 are connected in series between a direct current positive bus BUS+ and a direct current negative bus BUS-. The second output resistor R2, a second switch device K2, and a second internal power supply P2 are connected in series between the direct current positive bus BUS+ and the direct current negative bus BUS-. The third output resistor R3, a third switch device K3, and a third internal power supply P3 are connected in series between the direct current positive bus BUS+ and the direct current negative bus BUS-.

In this embodiment of this application, a controller is specifically configured to determine, when a current of the output resistor is greater than a preset current value, that a wiring error occurs in M direct current combiner boxes. It may be understood that, when wiring of the direct current combiner box is correct, the current of the output resistor is a fixed current value. When a wiring error occurs in the direct current combiner box, the current of the output resistor is greater than the preset current value. For example, when a second direct current combiner box 102 is reversely connected to the direct current bus, a short circuit occurs between the first internal power supply P1 and the second internal power supply P2, and currents of the first output resistor R1 and the second output resistor R2 are greater than the preset current value.

It can be learned that the photovoltaic system provided in this embodiment of this application may further include an output resistor. According to the photovoltaic system provided in this embodiment of this application, it may be further determined, by using a current of the output resistor, whether a direct current combiner box is incorrectly connected to the direct current bus.

In addition, the photovoltaic system provided in this embodiment of this application may be a photovoltaic energy storage system, and further includes an energy storage converter PCS. The energy storage converter PCS is connected to the direct current positive bus BUS+ and the direct current negative bus BUS-.

In this embodiment of this application, to detect whether wiring of the direct current combiner box is incorrect, a method for detecting a wiring error is further provided. The method is applied to the foregoing photovoltaic system. The method includes: controlling switch devices in at least two of the M direct current combiner boxes to be turned on, and all remaining switch devices to be turned off; and when a voltage of an output capacitor in a remaining direct current combiner box is less than a preset voltage value, determine that a wiring error occurs in the M direct current combiner boxes. The following describes, by using specific embodiments, specific application manners in which the method is applied to the photovoltaic system in embodiments of this application.

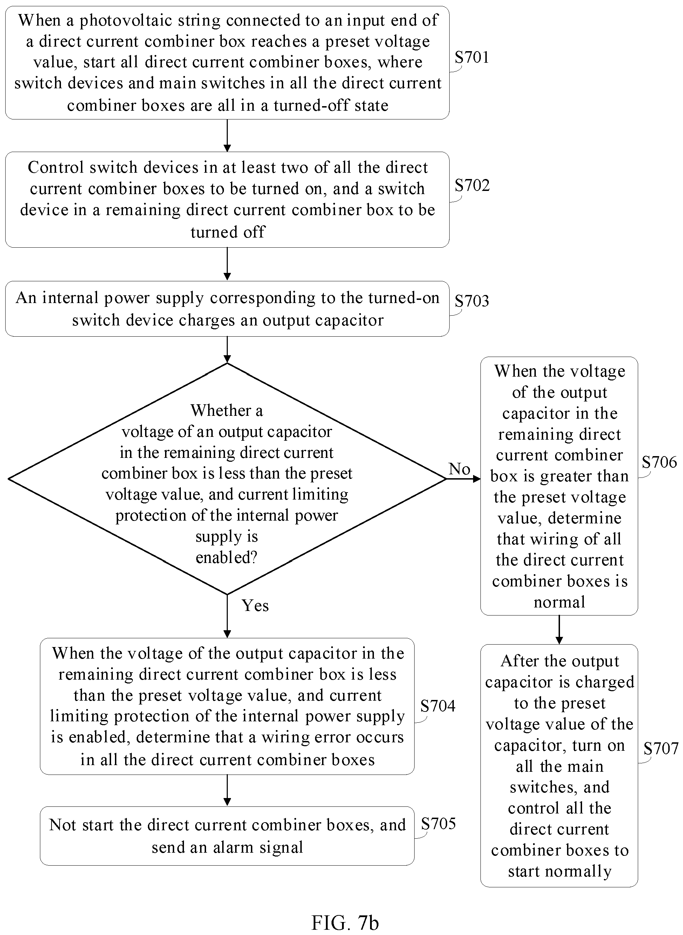

FIG. 7b is a flowchart of still another method for detecting a wiring error according to an embodiment of this application.

The method for detecting a wiring error provided in this embodiment of this application includes the following steps:
S701: When a photovoltaic string connected to an input end of a direct current combiner box reaches a preset voltage value, start all direct current combiner boxes, where switch devices and main switches in all the direct current combiner boxes are all in a turned-off state.

As shown in FIG. 7a, a photovoltaic system including three direct current combiner boxes and two photovoltaic strings is used as an example. In this embodiment of this application, direct current combiner boxes 101 to 103 are started, switch devices K1 to K3 are all turned off, and main switches Q1 to Q3 are all turned off.

It should be noted that all the direct current combiner boxes in this embodiment of this application are direct current combiner boxes connected between direct current buses in the photovoltaic system. When there are M direct current combiner boxes in the photovoltaic system, all the direct current combiner boxes in this embodiment of this application are equivalent to the M direct current combiner boxes.

S702: Control switch devices in at least two of the M direct current combiner boxes to be turned on, and a switch device in a remaining direct current combiner box to be turned off.

In an example, both the first switch device K1 in the first direct current combiner box 101 and the second switch device K2 in the second direct current combiner box 102 may be controlled to be turned on, and the third switch device K3 in the third direct current combiner box may be controlled to be turned off.

S703: An internal power supply corresponding to the turned-on switch device charges an output capacitor.

In other words, when the first switch device K1 is turned on, a first internal power supply P1 corresponding to K1 charges an output capacitor Cout1; and when the second switch device K2 is turned on, a first internal power supply P2 corresponding to K2 charges an output capacitor Cout2. In a normal case, two ends of each of output capacitors Cout1 to CoutM are respectively connected between a direct current positive bus BUS+ and a direct current negative bus BUS-. In other words, in a normal case, the output capacitors Cout1 to CoutM are all connected in parallel. When the first internal power supply P1 charges the first output capacitor Cout1 and the second internal power supply P2 charges the second output capacitor Cout2, voltages on Cout1 and Cout2 affect each other, and affect a voltage of another output capacitor. In other words, voltages of the output capacitors Cout1 to CoutM should be consistent.

S704: When a voltage of an output capacitor in the remaining direct current combiner box is less than the preset voltage value, and current limiting protection of the internal power supply is enabled, determine that a wiring error occurs in all the direct current combiner boxes.

As shown in FIG. 7a, a reverse connection of the second direct current combiner box 102 is used as an example. A positive output end of the first internal power supply P1 of the first direct current combiner box 101 is connected to the direct current positive bus BUS+, and a negative output end of the first internal power supply P1 is connected to the direct current negative bus BUS-. A positive output end of the second internal power supply P2 of the second direct current combiner box 102 is connected to the direct current negative bus BUS-, and a negative output end of the second internal power supply P2 is connected to the direct current positive bus BUS+. Therefore, current limiting protection of the internal power supplies P1 and P2 is enabled, the internal power supplies P1 and P2 each charge the output capacitors Cout1 to Cout3 in a reverse direction, the output capacitors Cout1 to Cout3 are equivalently short-circuited, and voltages on the output capacitors Cout1 to Cout3 are close to 0 V.

In this embodiment of this application, enabling of the current limiting protection of the internal power supply may be detected by detecting a current on an output resistor corresponding to the internal power supply. In an example, as shown in FIG. 7a, when it is detected that a current on a first output resistor R1 in a first soft-start circuit 111 is greater than a preset current, it is determined that current limiting protection of the first internal power supply P1 in the first soft-start circuit 111 is enabled.

In this embodiment of this application, the preset voltage value is positively correlated with a voltage of the internal power supply. Using a photovoltaic system including three direct current combiner boxes as an example, the preset voltage value may be equal to one third of a voltage of an internal unit, or close to one third of a voltage of an internal power supply.

S705: Not start power circuits of the direct current combiner boxes, and send an alarm signal.

In other words, power circuits of the direct current combiner boxes 101 to 103 are not started, the main switches Q1 to Q3 are kept turned-off, and an alarm signal is sent. In an example, in the solution provided in this application, the alarm signal may be sent to a monitoring board, to give an alarm to the external.

S706: When a voltage of an output capacitor in the remaining direct current combiner box is greater than the preset voltage value, determine that wiring of all the direct current combiner boxes is normal.

S707: After the output capacitor is charged to the preset voltage value of the capacitor, turn on all the main switches, and control all the direct current combiner boxes to start normally.

It can be learned that a controller provided in this embodiment of this application may further control the switch devices in at least two of the M direct current combiner boxes to be turned on, and determine, based on voltage values of the M output capacitors, whether a wiring error occurs in the M direct current combiner boxes.

In conclusion, the soft-start circuit in the photovoltaic system provided in this embodiment of this application may include an internal power supply and a main switch. According to the photovoltaic system provided in this embodiment of this application, the output capacitor in the soft-start circuit may be charged through the internal power supply in the soft-start circuit, and whether the direct current combiner box is incorrectly connected to the direct current bus may be determined based on the voltages on all the output capacitors.

In the photovoltaic system described in the foregoing embodiment, an output capacitor is charged by using a power supply in a soft-start circuit. In another possible implementation, in this embodiment of this application, the output capacitor may alternatively be charged by using a power supply outside the soft-start circuit. The following describes a solution in which the output capacitor is charged by using a voltage of a photovoltaic string.

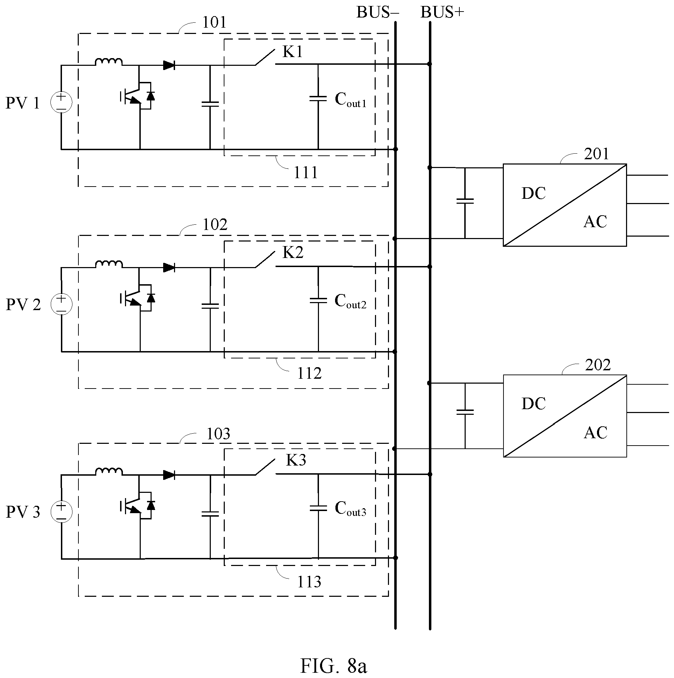

FIG. 8a is a schematic diagram of a structure of still another photovoltaic system according to an embodiment of this application.

In a possible implementation, in a soft-start circuit provided in this embodiment of this application, a switch device is connected in series between an input end and an output end of a direct current combiner box. When the switch device is turned on, a photovoltaic string corresponding to the turned-on switch device charges an output capacitor connected in series to the turned-on switch device. As shown in FIG. 8a, a first switch device K1 is connected in series between an input end and an output end of a first direct current combiner box 101, a second switch device K2 is connected in series between an input end and an output end of a second direct current combiner box 102, and a third switch device K3 is connected in series between an input end and an output end of a third direct current combiner box 103. The switch device in FIG. 8a is described by using an example in which the switch device is connected between a positive input end of the direct current combiner box and a positive output end of the direct current combiner box. In actual application, the switch device may alternatively be connected between a negative input end of the direct current combiner box and a negative output end of the direct current combiner box. This is not limited in this embodiment of this application.

In this embodiment of this application, when the switch device is turned on, a photovoltaic string corresponding to the turned-on switch device charges an output capacitor connected in series to the turned-on switch device. In an example, when the first switch device K1 is turned on, a photovoltaic string PV 1 charges a first output capacitor Cout1.

In this embodiment of this application, a controller is further configured to: determine that wiring of M direct current combiner boxes is normal, and control switch devices in the M direct current combiner boxes to be turned on, where positive output ends and negative output ends of the M direct current combiner boxes are respectively connected to a direct current positive bus and a direct current negative bus.

In this embodiment of this application, to detect whether wiring of a direct current combiner box is incorrect, a method for detecting a wiring error is further provided. The method is applied to the foregoing photovoltaic system.

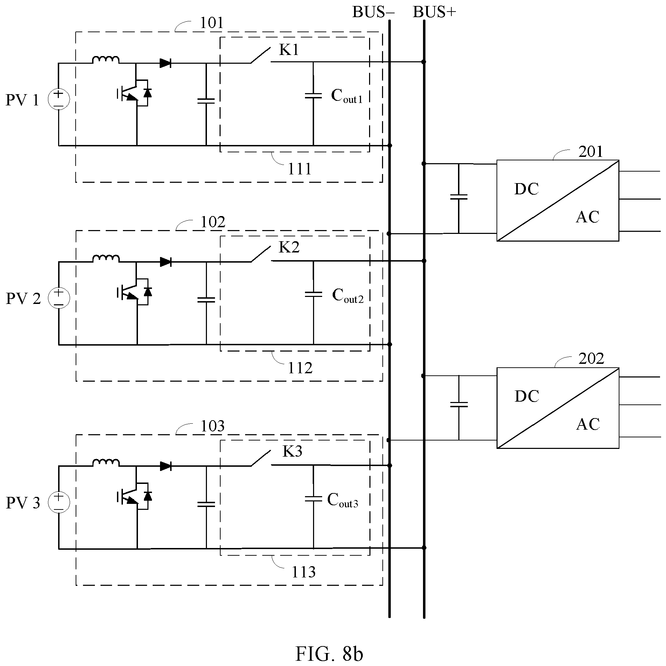

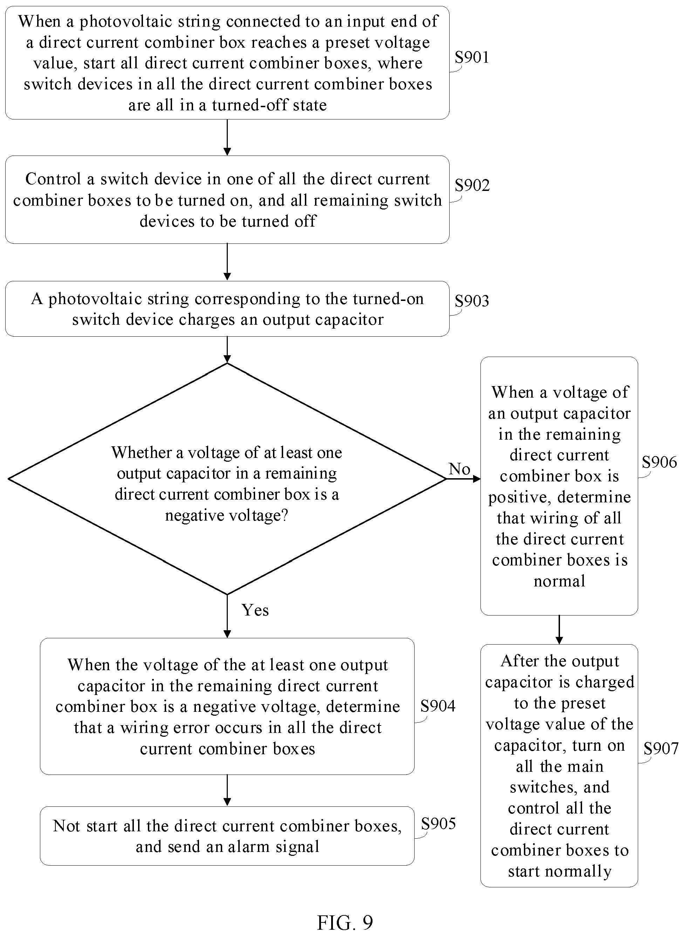

FIG. 8b is a schematic diagram of a structure of still yet another photovoltaic system with a wiring error according to an embodiment of this application. FIG. 9 is a flowchart of yet another method for detecting a wiring error according to an embodiment of this application.

The method for detecting a wiring error provided in this embodiment of this application includes the following steps:
S901: When a photovoltaic string connected to an input end of a direct current combiner box reaches a preset voltage value, start all direct current combiner boxes, where switch devices in all the direct current combiner boxes are all in a turned-off state.

As shown in FIG. 8b, a photovoltaic system including three direct current combiner boxes and two photovoltaic strings is used as an example. In this embodiment of this application, direct current combiner boxes 101 to 103 are started, and switch devices K1 to K3 are all turned off.

S902: Control a switch device in one of all the direct current combiner boxes to be turned on, and all remaining switch devices to be turned off.

In an example, the first switch device K1 in the first direct current combiner box 101 may be controlled to be turned on, and the switch devices K2 and K3 in the remaining direct current combiner boxes 102 and 103 may be both turned off.

S903: A photovoltaic string corresponding to the turned-on switch device charges an output capacitor.

In other words, when the first switch device K1 is turned on, a photovoltaic string PV 1 corresponding to the first switch device K1 charges an output capacitor Cout1. In a normal case, two ends of each of output capacitors Cout1 to Cout3 are respectively connected between a direct current positive bus BUS+ and a direct current negative bus BUS-. In other words, in a normal case, the output capacitors Cout1 to Cout3 are all connected in parallel. When the photovoltaic string PV 1 charges the first output capacitor Cout1, a voltage on Cout1 affects a voltage of another output capacitor, that is, voltages of other output capacitors Cout2 to Cout3 should be consistent with the voltage of Cout1.

S904: When a voltage of at least one output capacitor in a remaining direct current combiner box is a negative voltage, determine that a wiring error occurs in all the direct current combiner boxes.

As shown in FIG. 8b, a reverse connection of a third direct current combiner box 103 is used as an example. Positive output ends of the first direct current combiner box 101 and the second direct current combiner box 102 are connected to the direct current positive bus BUS+, and negative output ends of the first direct current combiner box 101 and the second direct current combiner box 102 are connected to the direct current negative bus BUS-. Therefore, first ends of the first output capacitor Cout1 and the second output capacitor Cout2 are connected to the direct current positive bus BUS+, and second ends of the first output capacitor Cout1 and the second output capacitor Cout2 are connected to the direct current negative bus. A positive output end of the third direct current combiner box 103 is connected to the direct current negative bus BUS-, and a negative output end of the third direct current combiner box 103 is connected to the direct current positive bus BUS+. Therefore, a first end of the third output capacitor Cout3 is connected to the direct current negative bus BUS-, and a second end of the third output capacitor Cout3 is connected to the direct current positive bus BUS+. As a result, a voltage of the third output capacitor Cout3 is opposite to a voltage of the first output capacitor Cout1 and a voltage of the second output capacitor Cout2, that is, the voltage of the third output capacitor Cout3 is negative. Therefore, it is determined that a wiring error occurs in all the direct current combiner boxes.

S905: Not start power circuits of all the direct current combiner boxes, and send an alarm signal.

In other words, power circuits of the direct current combiner boxes 101 to 103 are not started, the switch devices K1 to K3 are kept turned off, and an alarm signal is sent. In an example, in the solution provided in this application, the alarm signal may be sent to a monitoring board, to give an alarm to the external.

S906: When a voltage of an output capacitor in the remaining direct current combiner box is positive, determine that wiring of all the direct current combiner boxes is normal.

S907: After the output capacitor is charged to the preset voltage value of the capacitor, turn on all the main switches, and control all the direct current combiner boxes to start normally.

According to the method for detecting a wiring error provided in this embodiment, a switch device in one of all the direct current combiner boxes is controlled to be turned on, to detect whether a wiring error occurs in all the direct current combiner boxes. In another possible implementation, an embodiment of this application further provides a method for detecting a wiring error. In the method, switches in a plurality of direct current combiner boxes in all direct current combiner boxes are controlled to be turned on, to detect whether a wiring error occurs in all the direct current combiner boxes.

FIG. 10a is a flowchart of still yet another method for detecting a wiring error according to an embodiment of this application. FIG. 10b is a diagram of a structure of a further photovoltaic system with a wiring error according to an embodiment of this application.

As shown in FIG. 10a, the method is applied to the foregoing photovoltaic system. The method for detecting a wiring error provided in this embodiment of this application includes the following steps:
S1001: When a photovoltaic string connected to an input end of a direct current combiner box reaches a preset voltage value, start all direct current combiner boxes, where switch devices in all the direct current combiner boxes are all in a turned-off state.

As shown in FIG. 10b, a photovoltaic system including three direct current combiner boxes and two photovoltaic strings is used as an example. In this embodiment of this application, direct current combiner boxes 101 to 103 are started, and switch devices K1 to K3 are all turned off.

S1002: Control switch devices in two or more direct current combiner boxes in all the direct current combiner boxes to be turned on, and all remaining switch devices to be turned off.

In an example, both the first switch device K1 in the first direct current combiner box 101 and the second switch device K2 in the second direct current combiner box may be controlled to be turned on, and the third switch device K3 in the direct current combiner box 103 may be controlled to be turned off.

S1003: A photovoltaic string corresponding to the turned-on switch device charges an output capacitor.

In other words, when the first switch device K1 is turned on, a first internal power supply P1 corresponding to K1 charges an output capacitor Cout1; and when the second switch device K2 is turned on, a photovoltaic string PV 2 corresponding to K2 charges an output capacitor Cout2. In a normal case, two ends of each of output capacitors Cout1 to Cout3 are respectively connected between a direct current positive bus BUS+ and a direct current negative bus BUS-. In other words, in a normal case, the output capacitors Cout1 to Cout3 are all connected in parallel. When the photovoltaic string PV 1 charges the first output capacitor Cout1 and the photovoltaic string PV 2 charges the second output capacitor Cout2, voltages on Cout1 and Cout2 affect each other, and affect a voltage of another output capacitor. In other words, voltages of the output capacitors Cout1 to Cout3 should be consistent.

S1004: When a voltage of an output capacitor in a remaining direct current combiner box is less than the preset voltage value, determine that a wiring error occurs in all the direct current combiner boxes.

As shown in FIG. 10b, a reverse connection of the second direct current combiner box 103 is used as an example. A positive output end of the first internal power supply P1 of the first direct current combiner box 101 is connected to the direct current positive bus BUS+, and a negative output end of the photovoltaic string PV 1 is connected to the direct current negative bus BUS-. A positive output end of the photovoltaic string PV 2 of the second direct current combiner box 102 is connected to the direct current negative bus BUS-, and a negative output end of the photovoltaic string PV 2 is connected to the direct current positive bus BUS+. Therefore, the photovoltaic strings PV 1 and PV 2 each charge the output capacitors Cout1 to Cout3 in a reverse direction, the output capacitors Cout1 to Cout3 are equivalently short-circuited, and voltages on the output capacitors Cout1 to Cout3 are close to 0 V

It should be noted that, in this embodiment of this application, the preset voltage value is related to the voltage value of the photovoltaic string, and the preset voltage value may be obtained based on an actual structure of the photovoltaic system and the voltage value of the photovoltaic string.

S1005: Not start power circuits of all the direct current combiner boxes, and send an alarm signal.

In other words, power circuits of the direct current combiner boxes 101 to 103 are not started, the switch devices K1 to K3 are kept turned off, and an alarm signal is sent. In an example, in the solution provided in this application, the alarm signal may be sent to a monitoring board, to give an alarm to the external. In another example, in the method provided in this application, the alarm signal may alternatively be sent to a control station, to implement an alarm.

S1006: When the voltage of the output capacitor in the remaining direct current combiner box is greater than the preset voltage value, determine that wiring of all the direct current combiner boxes is normal.

As shown in FIG. 8, if a voltage of an output capacitor Cout3 in the third direct current combiner box 103 is greater than the preset voltage value, it is determined that wiring of the first direct current combiner box 101, the second direct current combiner box 102, and the third direct current combiner box 103 is normal.

S1007: After the output capacitor is charged to the preset voltage value of the capacitor, completely turn on all the switch devices, and control all the direct current combiner boxes to start normally.

In other words, the switch devices K1 to K3 are completely turned on, and the direct current combiner boxes 101 to 103 are controlled to start normally.

It may be understood that, in this embodiment of this application, to reduce impact of the output capacitors Cout1 to Cout3 on the normally running photovoltaic system, before all the direct current combiner boxes are started, the output capacitors Cout1 to Cout3 may be charged to preset voltage values of the capacitors, and then the switch devices K1 to K3 are controlled to be completely turned on. In a possible implementation, the switch device in this embodiment of this application may be a relay.

In conclusion, in a soft-start circuit provided in this embodiment of this application, the photovoltaic string and the output capacitor may be connected through the switch device, to charge the output capacitor, so as to determine, based on a voltage of the output capacitor, whether a wiring error occurs in the direct current combiner box.

In the solutions in which the output capacitor is charged through the photovoltaic string and the switch device in the foregoing embodiments, because a voltage of the photovoltaic string is large, performance of a device in the photovoltaic system may be affected when a wiring error occurs. Therefore, an embodiment of this application further provides a solution in which an output resistor and a switch device are connected in series, to reduce impact of a photovoltaic string on a device in a photovoltaic system.

FIG. 11 is a schematic diagram of a structure of yet another photovoltaic system according to an embodiment of this application.

In a possible implementation, a soft-start circuit provided in this embodiment of this application further includes a current-limiting resistor and a main switch. The current-limiting resistor and a switch device are connected in series and then connected in parallel to the main switch. The main switch is connected in series between an input end and an output end of a direct current combiner box. As shown in FIG. 11, a first current-limiting resistor Rs1 and a first switch device K1 are connected in series and then connected in parallel to two ends of a first main switch Q1, and the first main switch Q1 is connected in series between an input end and an output end of a direct current combiner box 101; a second current-limiting resistor Rs2 and a second switch device K2 are connected in series and then connected in parallel to two ends of a second main switch Q2, and the second main switch Q2 is connected in series between an input end and an output end of a direct current combiner box 102; and a third current-limiting resistor Rs3 and a third switch device K3 are connected in series and then connected in parallel to two ends of a third main switch Q3, and the third main switch Q3 is connected in series between an input end and an output end of a direct current combiner box 103.

Considering that a voltage of a photovoltaic string is large, in a possible implementation in this embodiment of this application, the switch device may be a soft-start relay or a switching transistor, and the main switch may be a relay or a contactor. It may be understood that if the soft-start relay is used as the switch device in this embodiment of this application, impact of the voltage of a photovoltaic string on a device in the photovoltaic system can be reduced, and safety of the device in the photovoltaic system can be ensured.

Further, this embodiment of this application further provides a current-limiting resistor and a switch device that are connected in series, so that a current in the photovoltaic system existing when the switch device is turned on can be reduced. This avoids damage to the device in the photovoltaic system caused by an excessively high current in the photovoltaic system due to a wiring error in the direct current combiner box.

In a possible implementation, a controller in this application is configured to: control at least one switch device in M direct current combiner boxes to be turned on, a remaining switch device to be turned off, and all main switches to be turned off; and determine, based on voltages of output capacitors in all soft-start circuits, whether a wiring error occurs in the M direct current combiner boxes. In an example, the controller in this embodiment of this application may control the first switch device K1 to be turned on, and the second switch device K2 and the third switch device K3 to be turned off, so that a photovoltaic string PV 1 charges a first output capacitor Cout1, and the first output capacitor Cout1 charges a second output capacitor Cout2 and a third output capacitor Cout3 through a direct current bus.

In a possible implementation, the controller in this application is further configured to: when determining that wiring of the M direct current combiner boxes is normal, control main switches in the M direct current combiner boxes to be turned on, so that the photovoltaic system in this embodiment of this application supplies power to a power grid or an electrical device.

To help better understand the method for detecting a wiring error in the photovoltaic system provided in embodiments of this application, the following describes, by using specific embodiments, the method for detecting a wiring error in the photovoltaic system provided in embodiments of this application.

FIG. 12 is a schematic diagram of a structure of a still further photovoltaic system with a wiring error according to an embodiment of this application. FIG. 13 is a flowchart of a further method for detecting a wiring error according to an embodiment of this application.

The method for detecting a wiring error provided in this embodiment of this application includes the following steps:
S1301: When a photovoltaic string connected to an input end of a direct current combiner box reaches a preset voltage value, start all direct current combiner boxes, where switch devices and main switches in all the direct current combiner boxes are all in a turned-off state.

As shown in FIG. 12, a photovoltaic system including three direct current combiner boxes and two photovoltaic strings is used as an example. In this embodiment of this application, direct current combiner boxes 101 to 103 are started, and switch devices K1 to K3 and main switches Q1 to Q3 are all turned off.

S1302: Control a switch device in one of all the direct current combiner boxes to be turned on, and all remaining switch devices to be turned off.

In an example, the first switch device K1 in the first direct current combiner box 101 may be controlled to be turned on, and the first switch device K2 and the third switch device K3 in the remaining direct current combiner boxes 102 and 103 may be both turned off.

S1303: A photovoltaic string corresponding to the turned-on switch device charges an output capacitor.

In other words, when the first switch device K1 is turned on, a photovoltaic string PV 1 corresponding to the first switch device K1 charges an output capacitor Cout1. In a normal case, two ends of each of output capacitors Cout1 to Cout3 are respectively connected between a direct current positive bus BUS+ and a direct current negative bus BUS-. In other words, in a normal case, the output capacitors Cout1 to Cout3 are all connected in parallel. When the photovoltaic string PV 1 charges the first output capacitor Cout1, a voltage on Cout1 affects a voltage of another output capacitor, that is, voltages of other output capacitors Cout2 to Cout3 should be consistent with the voltage of Cout1.

S1304: When a voltage of at least one output capacitor in a remaining direct current combiner box is a negative voltage, determine that a wiring error occurs in all the direct current combiner boxes.

As shown in FIG. 12, a reverse connection of a third direct current combiner box 103 is used as an example. Positive output ends of the first direct current combiner box 101 and the second direct current combiner box 102 are connected to the direct current positive bus BUS+, and negative output ends of the first direct current combiner box 101 and the second direct current combiner box 102 are connected to the direct current negative bus BUS-. Therefore, first ends of the first output capacitor Cout1 and the second output capacitor Cout2 are connected to the direct current positive bus BUS+, and second ends of the first output capacitor Cout1 and the second output capacitor Cout2 are connected to the direct current negative bus. A positive output end of the third direct current combiner box 103 is connected to the direct current negative bus BUS-, and a negative output end of the third direct current combiner box 103 is connected to the direct current positive bus BUS+. Therefore, a first end of the third output capacitor Cout3 is connected to the direct current negative bus BUS-, and a second end of the third output capacitor Cout3 is connected to the direct current positive bus BUS+. As a result, a voltage of the third output capacitor Cout3 is opposite to a voltage of the first output capacitor Cout1 and a voltage of the second output capacitor Cout2, that is, the voltage of the third output capacitor Cout3 is negative. Therefore, it is determined that a wiring error occurs in all the direct current combiner boxes.

S1305: Not start power circuits of all the direct current combiner boxes, and send an alarm signal.

In other words, power circuits of the direct current combiner boxes 101 to 103 are not started, and the switch devices K1 to K3 and the main switches Q1 to Q3 are kept turned off, and an alarm signal is sent. In an example, in the solution provided in this application, the alarm signal may be sent to a monitoring board, to give an alarm to the external.

S1306: When a voltage of an output capacitor in the remaining direct current combiner box is positive, determine that wiring of all the direct current combiner boxes is normal.

As shown in FIG. 11, if voltages of output capacitors of the second direct current combiner box 102 and the third direct current combiner box 103 are both positive, it is determined that wiring of all the direct current combiner boxes is normal.

S1307: After the output capacitor is charged to the preset voltage value of the capacitor, turn off all the switch devices, turn on all the main switches, and control all the direct current combiner boxes to start normally.

It may be understood that, in this embodiment of this application, to prevent a current-limiting resistor from affecting running efficiency of the photovoltaic system during normal running, in a possible manner, after it is determined that wiring of all the direct current combiner boxes is normal, all the switch devices may be first turned off, and then all the main switches are turned on, and all the direct current combiner boxes are controlled to start normally. As shown in FIG. 11, if it is determined that wiring of all the direct current combiner boxes is normal, the switch devices K1 to K3 may be first turned off, then the main switches Q1 to Q3 are turned on, and the direct current combiner boxes 101 to 103 are controlled to start normally.

According to the method for detecting a wiring error provided in this embodiment, a switch device in one of all the direct current combiner boxes is controlled to be turned on, to detect whether a wiring error occurs in all the direct current combiner boxes. In another possible implementation, an embodiment of this application further provides a method for detecting a wiring error. In the method, switches in a plurality of direct current combiner boxes in all direct current combiner boxes are controlled to be turned on, to detect whether a wiring error occurs in all the direct current combiner boxes.

FIG. 14 is a flowchart of a still further method for detecting a wiring error according to an embodiment of this application. FIG. 15 is a diagram of a structure of a yet further photovoltaic system with a wiring error according to an embodiment of this application.

The method is applied to the photovoltaic system provided in the foregoing embodiment. The method for detecting a wiring error provided in this embodiment of this application includes the following steps:
S1401: When a photovoltaic string connected to an input end of a direct current combiner box reaches a preset voltage value, start all direct current combiner boxes, where switch devices in all the direct current combiner boxes are all in a turned-off state.

As shown in FIG. 15, a photovoltaic system including three direct current combiner boxes and two photovoltaic strings is used as an example. In this embodiment of this application, direct current combiner boxes 101 to 103 are started, and switch devices K1 to K3 and main switches Q1 to Q3 are all turned off.

S1402: Control switch devices in two or more direct current combiner boxes in all the direct current combiner boxes to be turned on, and all remaining switch devices to be turned off.

In an example, both the first switch device K1 in the first direct current combiner box 101 and the second switch device K2 in the second direct current combiner box may be controlled to be turned on, and the third switch device K3 in the direct current combiner box 103 may be controlled to be turned off.

S1403: A photovoltaic string corresponding to the turned-on switch device charges an output capacitor.

In other words, when the first switch device K1 is turned on, a first internal power supply P1 corresponding to K1 charges an output capacitor Cout1; and when the second switch device K2 is turned on, a photovoltaic string PV 2 corresponding to K2 charges an output capacitor Cout2. In a normal case, two ends of each of output capacitors Cout1 to Cout3 are respectively connected between a direct current positive bus BUS+ and a direct current negative bus BUS-. In other words, in a normal case, the output capacitors Cout1 to Cout3 are all connected in parallel. When the photovoltaic string PV 1 charges the first output capacitor Cout1 and the photovoltaic string PV 2 charges the second output capacitor Cout2, voltages on Cout1 and Cout2 affect each other, and affect a voltage of another output capacitor. In other words, voltages of the output capacitors Cout1 to Cout3 should be consistent.

S1404: When a voltage of an output capacitor in a remaining direct current combiner box is less than the preset voltage value, determine that a wiring error occurs in all the direct current combiner boxes.

As shown in FIG. 15, a reverse connection of the second direct current combiner box 103 is used as an example. A positive output end of the first internal power supply P1 of the first direct current combiner box 101 is connected to the direct current positive bus BUS+, and a negative output end of the photovoltaic string PV 1 is connected to the direct current negative bus BUS-. A positive output end of the photovoltaic string PV 2 of the second direct current combiner box 102 is connected to the direct current negative bus BUS-, and a negative output end of the photovoltaic string PV 2 is connected to the direct current positive bus BUS+. Therefore, the photovoltaic strings PV 1 and PV 2 each charge the output capacitors Cout1 to Cout3 in a reverse direction, the output capacitors Cout1 to Cout3 are equivalently short-circuited, and voltages on the output capacitors Cout1 to Cout3 are close to 0 V

S1405: Not start power circuits of all the direct current combiner boxes, and send an alarm signal.

In other words, power circuits of the direct current combiner boxes 101 to 103 are not started, the switch devices K1 to K3 are kept turned off, and an alarm signal is sent. In an example, in the solution provided in this application, the alarm signal may be sent to a monitoring board, to give an alarm to the external. In another example, in the method provided in this application, the alarm signal may alternatively be sent to a control station, to implement an alarm.

S1406: When the voltage of the output capacitor in the remaining direct current combiner box is greater than the preset voltage value, determine that wiring of all the direct current combiner boxes is normal.

S1407: After the output capacitor is charged to the preset voltage value of the capacitor, turn off all the switch devices, turn on all the main switches, and control all the direct current combiner boxes to start normally.

It may be understood that, in this embodiment of this application, to reduce impact of the output capacitors Cout1 to Cout3 on the normally running photovoltaic system, before all the direct current combiner boxes are started, the output capacitors Cout1 to Cout3 may be charged to preset voltage values of the capacitors, the switch devices K1 to K3 are turned off, and the main switches Q1 to Q3 are turned on. In a possible implementation, the switch device in this embodiment of this application may be a relay.

In conclusion, in a soft-start circuit provided in this embodiment of this application, the photovoltaic string and the output capacitor may be connected through a current-limiting resistor and the switch device, to charge the output capacitor, so as to determine, based on a voltage of the output capacitor, whether a wiring error occurs in the direct current combiner box.

Embodiment of a direct current combiner box:

Based on the photovoltaic system and the method for detecting a wiring error provided in the foregoing embodiments, an embodiment of this application further provides a direct current combiner box. An example in which a plurality of direct current combiner boxes are connected in parallel to a direct current bus is used in the foregoing photovoltaic system. The direct current combiner box described below generally refers to any one of the foregoing direct current combiner boxes connected in parallel. To better understand the direct current combiner box in embodiments of this application, the following describes the direct current combiner box in the embodiments of this application by using a specific embodiment.

FIG. 16 is a schematic diagram of a direct current combiner box according to an embodiment of this application.

As shown in FIG. 16, an input end of a direct current combiner box 101 provided in this embodiment is configured to connect to a corresponding photovoltaic string, a positive output end and a negative output end of each of M direct current combiner boxes are respectively configured to connect to a direct current positive bus BUS+ and a direct current negative bus BUS-, and M is an integer greater than or equal to 2. A positive input end and a negative input end of an inverter 201 in this embodiment of this application are respectively configured to connect to the direct current positive bus BUS+ and the direct current negative bus BUS-.

The direct current combiner box 101 includes a soft-start circuit 111. The soft-start circuit 111 includes at least a switch device and an output capacitor that are connected in series. The output capacitor is connected in parallel to the positive output end and the negative output end of the direct current combiner box 101. A switch device in at least one of the M direct current combiner boxes is turned on, an output capacitor connected in series to the turned-on switch device is charged, and a remaining switch device is turned off. Whether a wiring error occurs in the M direct current combiner boxes is determined based on voltages of output capacitors in at least some of the soft-start circuits. If wiring of one of the M direct current combiner boxes is detected as faulty, it is considered that a wiring error occurs.

In this embodiment of this application, in a possible implementation, the direct current combiner box further includes a controller.

The controller is configured to: control a switch device in one of the M direct current combiner boxes to be turned on, and all remaining switch devices to be turned off; and when a voltage of at least one output capacitor in a remaining direct current combiner box is a negative voltage, determine that a wiring error occurs in the M direct current combiner boxes.

In this embodiment of this application, in a possible implementation, the direct current combiner box further includes a controller. The controller is configured to: control switch devices in at least two of the M direct current combiner boxes to be turned on, and all remaining switch devices to be turned off; and when a voltage of an output capacitor in a remaining direct current combiner box is less than a preset voltage value, determine that a wiring error occurs in the M direct current combiner boxes.

In this embodiment of this application, in a possible implementation, the switch device is connected in series between the input end and an output end of the direct current combiner box; and when the switch device is turned on, a photovoltaic string corresponding to the turned-on switch device charges an output capacitor connected in series to the turned-on switch device.

In this embodiment of this application, in a possible implementation, the soft-start circuit further includes a current-limiting resistor and a main switch; the current-limiting resistor and the switch device are connected in series and then connected in parallel to the main switch; and the main switch is connected in series between the input end and the output end of the direct current combiner box. The controller is configured to: control at least one switch device in the M direct current combiner boxes to be turned on, a remaining switch device to be turned off, and all main switches to be turned off; and determine, based on voltages of output capacitors in all the soft-start circuits, whether a wiring error occurs in the M direct current combiner boxes.

In this embodiment of this application, in a possible implementation, the soft-start circuit further includes an internal power supply and a main switch. The main switch is connected in series between the input end and the output end of the direct current combiner box. The internal power supply and the switch device are connected in series and then connected in parallel to the output capacitor, and when the switch device is turned on, the internal power supply charges a corresponding output capacitor. The controller is configured to: control at least one switch device in the M direct current combiner boxes to be turned on, a remaining switch device to be turned off, and all main switches to be turned off; and determine, based on voltages of output capacitors in all the soft-start circuits, whether a wiring error occurs in the M direct current combiner boxes.

It should be noted that the direct current combiner box in this embodiment of this application may be applied to any soft-start circuit in the foregoing embodiments. This is not limited in this embodiment of this application.

It should be understood that in this application, "at least one (item)" refers to one or more and "a plurality of" refers to two or more. The term "and/or" is used to describe an association relationship between associated objects, and indicates that three relationships may exist. For example, "A and/or B" may indicate the following three cases: Only A exists, only B exists, and both A and B exist, where A and B may be singular or plural. A character "/" generally indicates an "or" relationship between the associated objects. "At least one of the following items (pieces)" or a similar expression thereof refers to any combination of these items, including any combination of singular items (pieces) or plural items (pieces). For example, at least one of a, b, or c may indicate a, b, c, a and b, a and c, b and c, or a, b, and c, where a, b, and c may be singular or plural.

The foregoing descriptions are merely preferred embodiments of this application, but are not intended to limit this application in any form. Although the preferred embodiments of this application are disclosed above, embodiments are not intended to limit this application. By using the method and the technical content disclosed above, any person of ordinary skill in the art can make a plurality of possible changes and modifications on the technical solutions of this application, or amend the technical solutions thereof to be embodiments with equal effects through equivalent variations without departing from the protection scope of the technical solutions of this application. Therefore, any simple amendment, equivalent variation, and modification made on the above embodiments according to the technical essence of this application without departing from the content of the technical solutions of this application shall fall within the protection scope of the technical solutions of this application.

## Claims

1. A photovoltaic system, comprising M direct current combiner boxes and N inverters, wherein both M and N are integers greater than or equal to 2, positive output ends and negative output ends of the M direct current combiner boxes are respectively configured to connect to a direct current positive bus and a direct current negative bus, an input end of each of the M direct current combiner boxes is configured to connect to a corresponding photovoltaic string, and positive input ends and negative input ends of the N inverters are respectively configured to connect the direct current positive bus and the direct current negative bus;
each of the M direct current combiner boxes comprises a soft-start circuit;
the soft-start circuit comprises at least a switch device and an output capacitor that are connected in series, and the output capacitor is connected in parallel to a positive output end and a negative output end of the direct current combiner box; and
a switch device in at least one of the M direct current combiner boxes is turned on, an output capacitor connected in series to the turned-on switch device is charged, a remaining switch device is turned off, and whether a wiring error occurs in the M direct current combiner boxes is determined based on voltages of output capacitors in at least some of the soft-start circuits.

2. The photovoltaic system according to claim 1, further comprising a controller, wherein the controller is configured to: control a switch device in one of the M direct current combiner boxes to be turned on, and all remaining switch devices to be turned off; and when a voltage of at least one output capacitor in a remaining direct current combiner box is a negative voltage, determine that a wiring error occurs in the M direct current combiner boxes.

3. The photovoltaic system according to claim 1, further comprising a controller, wherein the controller is configured to: control switch devices in at least two of the M direct current combiner boxes to be turned on, and all remaining switch devices to be turned off; and when a voltage of an output capacitor in a remaining direct current combiner box is less than a preset voltage value, determine that a wiring error occurs in the M direct current combiner boxes.

4. The photovoltaic system according to claim 2 or 3, wherein the switch device is connected in series between the input end and an output end of the direct current combiner box; and when the switch device is turned on, a photovoltaic string corresponding to the turned-on switch device charges an output capacitor connected in series to the turned-on switch device; and
the controller is further configured to: determine that wiring of the M direct current combiner boxes is normal, and control switch devices in the M direct current combiner boxes to be turned on, wherein positive output ends and negative output ends of the M direct current combiner boxes are respectively connected to the direct current positive bus and the direct current negative bus.

5. The photovoltaic system according to claim 2 or 3, wherein the soft-start circuit further comprises a current-limiting resistor and a main switch;
the current-limiting resistor and the switch device are connected in series and then connected in parallel to the main switch;
the main switch is connected in series between the input end and an output end of the direct current combiner box;
the controller is configured to: control at least one switch device in the M direct current combiner boxes to be turned on, a remaining switch device to be turned off, and all the main switches to be turned off; and determine, based on voltages of output capacitors in all the soft-start circuits, whether a wiring error occurs in the M direct current combiner boxes; and
the controller is further configured to: determine that wiring of the M direct current combiner boxes is normal, and control the main switches in the M direct current combiner boxes to be turned on.

6. The photovoltaic system according to claim 2 or 3, wherein the soft-start circuit further comprises an internal power supply and a main switch;
the main switch is connected in series between the input end and an output end of the direct current combiner box;
the internal power supply and the switch device are connected in series and then connected in parallel to the output capacitor, and when the switch device is turned on, the internal power supply charges a corresponding output capacitor;
the controller is configured to: control at least one switch device in the M direct current combiner boxes to be turned on, a remaining switch device to be turned off, and all the main switches to be turned off; and determine, based on voltages of output capacitors in all the soft-start circuits, whether a wiring error occurs in the M direct current combiner boxes; and
the controller is further configured to: determine that wiring of the M direct current combiner boxes is normal, and control the main switches in the M direct current combiner boxes to be turned on.

7. The photovoltaic system according to claim 6, wherein the controller is further configured to determine that a wiring error occurs in the M direct current combiner boxes when an output current of the internal power supply is greater than a preset current value.

8. The photovoltaic system according to claim 7, wherein the soft-start circuit further comprises an output resistor;
the output resistor, the switch device, and the internal power supply are all connected in series; and
the controller is specifically configured to determine that a wiring error occurs in the M direct current combiner boxes when a current of the output resistor is greater than the preset current value.

9. The photovoltaic system according to any one of claims 6 to 8, wherein the internal power supply is a flyback power supply.

10. The photovoltaic system according to any one of claims 2 to 9, wherein there are M controllers, the M controllers are in a one-to-one correspondence with the M direct current combiner boxes, and each of the controllers is located inside a corresponding direct current combiner box.

11. The photovoltaic system according to any one of claims 1 to 10, wherein the soft-start circuit is connected to a positive output end or a negative output end of the direct current combiner box, or an input end of the direct current combiner box.

12. The photovoltaic system according to any one of claims 1 to 11, wherein the switch device is a semiconductor switch or a relay.

13. The photovoltaic system according to any one of claims 1 to 12, further comprising an energy storage converter, wherein
the energy storage converter is configured to connect to the direct current positive bus and the direct current negative bus.

14. A direct current combiner box, wherein an input end of the direct current combiner box is configured to connect to a corresponding photovoltaic string, a positive output end and a negative output end of each of M direct current combiner boxes are respectively configured to connect to a direct current positive bus and a direct current negative bus, and M is an integer greater than or equal to 2;
the direct current combiner box comprises a soft-start circuit;
the soft-start circuit comprises at least a switch device and an output capacitor that are connected in series, and the output capacitor is connected in parallel to the positive output end and the negative output end of the direct current combiner box; and
a switch device in at least one of the M direct current combiner boxes is turned on, an output capacitor connected in series to the turned-on switch device is charged, a remaining switch device is turned off, and whether a wiring error occurs in the M direct current combiner boxes is determined based on voltages of output capacitors in at least some of the soft-start circuits.

15. The combiner box according to claim 14, further comprising a controller, wherein
the controller is configured to: control a switch device in one of the M direct current combiner boxes to be turned on, and all remaining switch devices to be turned off; and when a voltage of at least one output capacitor in a remaining direct current combiner box is a negative voltage, determine that a wiring error occurs in the M direct current combiner boxes.

16. The combiner box according to claim 14, further comprising a controller, wherein
the controller is configured to: control switch devices in at least two of the M direct current combiner boxes to be turned on, and all remaining switch devices to be turned off; and when a voltage of an output capacitor in a remaining direct current combiner box is less than a preset voltage value, determine that a wiring error occurs in the M direct current combiner boxes.

17. The combiner box according to claim 15 or 16, wherein the switch device is connected in series between the input end and an output end of the direct current combiner box; and when the switch device is turned on, a photovoltaic string corresponding to the turned-on switch device charges an output capacitor connected in series to the turned-on switch device.

18. The combiner box according to claim 15 or 16, wherein the soft-start circuit further comprises a current-limiting resistor and a main switch;
the current-limiting resistor and the switch device are connected in series and then connected in parallel to the main switch;
the main switch is connected in series between the input end and an output end of the direct current combiner box; and
the controller is configured to: control at least one switch device in the M direct current combiner boxes to be turned on, a remaining switch device to be turned off, and all the main switches to be turned off; and determine, based on voltages of output capacitors in all the soft-start circuits, whether a wiring error occurs in the M direct current combiner boxes.

19. The combiner box according to claim 15 or 16, wherein the soft-start circuit further comprises an internal power supply and a main switch;
the main switch is connected in series between the input end and an output end of the direct current combiner box;
the internal power supply and the switch device are connected in series and then connected in parallel to the output capacitor, and when the switch device is turned on, the internal power supply charges a corresponding output capacitor; and
the controller is configured to: control at least one switch device in the M direct current combiner boxes to be turned on, a remaining switch device to be turned off, and all the main switches to be turned off; and determine, based on voltages of output capacitors in all the soft-start circuits, whether a wiring error occurs in the M direct current combiner boxes.

20. A method for detecting a wiring error, applied to a photovoltaic system, wherein the photovoltaic system comprises M direct current combiner boxes and N inverters, both M and N are integers greater than or equal to 2, positive output ends and negative output ends of the M direct current combiner boxes are respectively configured to connect to a direct current positive bus and a direct current negative bus, an input end of each of the M direct current combiner boxes is configured to connect to a corresponding photovoltaic string, positive input ends and negative input ends of the N inverters are respectively configured to connect the direct current positive bus and the direct current negative bus, each of the M direct current combiner boxes comprises a soft-start circuit, the soft-start circuit comprises at least a switch device and an output capacitor that are connected in series, and the output capacitor is connected in parallel to the positive output end and the negative output end of the direct current combiner box; and
the method comprises:
controlling a switch device in at least one of the M direct current combiner boxes to be turned on, an output capacitor connected in series to the turned-on switch device to be charged, and a remaining switch device to be turned off; and
determining, based on voltages of output capacitors in at least some of the soft-start circuits, whether a wiring error occurs in the M direct current combiner boxes.

21. The method according to claim 20, wherein the controlling a switch device in at least one of the M direct current combiner boxes to be turned on, an output capacitor connected in series to the turned-on switch device to be charged, and a remaining switch device to be turned off specifically comprises:
controlling a switch device in one of the M direct current combiner boxes to be turned on, and all remaining switch devices to be turned off; and
the determining, based on voltages of output capacitors in all the soft-start circuits, whether a wiring error occurs in the M direct current combiner boxes specifically comprises:
when a voltage of at least one output capacitor in a remaining direct current combiner box is a negative voltage, determining that a wiring error occurs in the M direct current combiner boxes.

22. The method according to claim 20, wherein the controlling a switch device in at least one of the M direct current combiner boxes to be turned on, an output capacitor connected in series to the turned-on switch device to be charged, and a remaining switch device to be turned off specifically comprises:
controlling switch devices in at least two of the M direct current combiner boxes to be turned on, and all remaining switch devices to be turned off; and
the determining, based on voltages of output capacitors in all the soft-start circuits, whether a wiring error occurs in the M direct current combiner boxes specifically comprises:
if a voltage of an output capacitor in a remaining direct current combiner box is less than a preset voltage value, determining that a wiring error occurs in the M direct current combiner boxes.
